# EUROPÄISCHE PATENTSCHRIFT

(11) **EP 1 692 720 B1**
(45) Veröffentlichungstag und Bekanntmachung des Hinweises auf die Patenterteilung: **24.11.2010**
(21) Anmeldenummer: 04803557.0
(22) Anmeldetag: 01.12.2004
(51) Int. Cl.: H01L 21/8228, H01L 27/082

(54) **KOMPLEMENT RE BIPOLAR-HALBLEITERVORRICHTUNG**
BIPOLAR COMPLEMENTARY SEMICONDUCTOR DEVICE
DISPOSITIF SEMI-CONDUCTEUR BIPOLAIRE COMPLEMENTAIRE

(30) Priorität: 05.12.2003 DE 10358047
(43) Veröffentlichungstag der Anmeldung: 23.08.2006
(73) Patentinhaber: IHP GmbH-Innovations for High Performance Microelectronics / Leibniz-Institut für innovative Mikroelektronik, 15236 Frankfurt / Oder (DE)
(72) Erfinder: HEINEMAN, Bernd, 15234 Frankfurt (Oder) (DE); DREWS, Jürgen, 15230 Frankfurt (Oder) (DE); MARSCHMAYER, Steffen, 15232 Frankfurt (Oder) (DE); RÜCKER, Holger, 15526 Bad Saarow (DE)
(74) Vertreter: Eisenführ, Speiser & Partner
(86) Internationale Anmeldenummer: PCT/EP2004/013855
(87) Internationale Veröffentlichungsnummer: WO 2005/055289

(56) Entgegenhaltungen:
- WO-A-03/046948
- US-A1- 2003 146 468
- US-A1- 2003 146 477
- US-A1- 2003 162 360
- US-A1- 2003 219 952
- US-B1- 6 222 250
- PATENT ABSTRACTS OF JAPAN Bd. 2000, Nr. 10, 17. November 2000 (2000-11-17) -& JP 2000 188296 A (SONY CORP), 4. Juli 2000 (2000-07-04)

## Beschreibung

Die Erfindung betrifft eine komplementäre Bipolar-Halbleitervorrichtung, nachfolgend auch CBi-Halbleitervorrichtung genannt, mit einem Substrat eines ersten Leitfähigkeitstyps und einer Anzahl darin vorgesehener aktiver Gebiete, die in lateraler Richtung von flachen Feldisolationsgebieten begrenzt werden, bei der in einer ersten Teilanzahl der aktiven Gebiete vertikale npn- Bipolartransistoren mit epitaxialer Basis, und in einer zweiten Teilanzahl der aktiven Gebiete vertikale pnp-Bipolartransistoren mit epitaxialer Basis angeordnet sind, wobei entweder ein Transistortyp oder beide Transistortypen in ein und demselben jeweiligen aktiven Gebiet sowohl ein Kollektorgebiet als auch ein Kollektorkontaktgebiet aufweisen. Weiterhin betrifft die Erfindung ein Verfahren zur Herstellung einer solchen komplementären Bipolar-Halbleitervorrichtung.

Die vorliegende Anmeldung bezieht die deutsche Patentanmeldung DE10358047.6 vom 5.12.2003, deren Priorität beansprucht wird, im Sinne einer "Incorporation by Reference" nach amerikanischem Recht vollständig mit ein.

Die Leistungsfähigkeit von Bipolartransistoren (engl.: Bipolar Junction Transistor, BJT) auf Siliziumbasis ist im Hochgeschwindigkeitsbereich durch die Verwendung einer Hetero-Basisschicht, die mittels Epitaxie hergestellt wird, wesentlich verbessert worden. Ein weiterer Leistungsschub ist bei npn-Hetero-bipolartransistoren (HBTs) durch den zusätzlichen Einbau von Kohlenstoff in eine mit Bor dotierte Basis aus Silizium-Germanium (SiGe) ausgelöst worden.

Aus schaltungstechnischen Gründen ist es oft vorteilhaft, auf einem Chip gleichzeitig über npn- und pnp-Transistoren zu verfügen.

Darüber hinaus kann auch die Integration mit komplementären Metall-Oxid-Halbleiter (engl.: Complementary Metal Oxide Semiconductor, CMOS)-Transistoren zusätzliche Vorteile erbringen.

Wesentliche Merkmale eines kostengünstig herstellbaren Hochgeschwindigkeits-Bipolartransistors mit epitaxialer Basis sind in der WO 03/046948 A2 vorgestellt. Der dort beschriebene Transistor ermöglicht insbesondere eine vereinfachte Integration entweder eines npn- oder eines pnp-Hochgeschwindigkeits-HBTs in eine CMOS-)Technologie. Eine solche Technologie wird als BiCMOS-Technologie bezeichnet. Der WO 03/046948 A2 ist jedoch nicht zu entnehmen, wie npn- und pnp-Transistoren gemeinsam in einer CBi-Halbleitervorrichtung integriert werden können.

Bei pnp-Hetero-Bipolartransistoren (pnp-HBTs), die im Hochgeschwindigkeitsbereich arbeiten, sind im Vergleich mit den Fortschritten bei der Weiterentwicklung von npn-HBTs, insbesondere von npn-SiGe-HBTs die Fortschritte in den vergangenen Jahren eher gering gewesen. Für diese geringen Fortschritte bei der Verbesserung der Hochgeschwindigkeitseigenschaften von pnp-HBTs sind hauptsächlich folgende Gründe zu nennen:
a) Der Typ des Heteroübergangs von Si/SiGe kommt guten Hochfrequenzeigenschaften bei npn-Transistoren entgegen, während diese Art des Heteroübergangs die Leistungsfähigkeit von pnp-Transistoren beeinträchtigen kann, vgl. D. V. Singh, J.L. Hoyt und J. F. Gibbons:"Novel epitaxial p-Si/n-Si1-yCy/p-Si heterojunction bipolar transistors", IEDM 2000, pp. 749-752, oder D. V. Singh, J.L. Hoyt und J. F. Gibbons:"Effect of band a-lignment and density of states on the collector current in p-Si/n-Si1-yCy/p-Si HBTs", IEEE Trans. Electron. Devices, vol. 50, pp. 425-432, Feb. 2003.
b) Aufgrund von Abscheide- und Diffusionseigenschaften der jeweiligen Dotanden lassen sich die Anforderungen an das Dotierungsprofil von npn-Hochgeschwindigkeitstransistoren in einem BiCMOS-Prozess leichter erfüllen als die für einen pnp-Transistor.
c) Die Prozesskomplexität herkömmlicher komplementären Bipolar- oder BiCMOS-Prozesse ist so groß und der wechselseitige Einfluss der Prozessmodule auf Bauelementeparameter so erheblich, dass wenige Ansätze existieren, die auf eine Verbesserung der Hochfrequenzeigenschaften von pnp-Transistoren in einer CBiCMOS-Halbleitervorrichtung zielen.

Dem heutigen Stand der Technik entsprechende Gestaltungsmerkmale von komplementären Bipolartransistoren und Verfahrensschritte einer komplementären SiGe-BiCMOS Technologie sind in B. El-Kareh, S. Balster, W. Leitz, P. Steinmann, H. Yasuda, M. Corsi, K. Dawoodi, C. Dirnecker, P. Foglietti, A. Haesler, P. Menz, M. Ramin, T. Scharnagl, M. Schiekofer, M. Schober, U. Schulz, L. Swanson, D. Tatman, M. Waitschull, J.W. Weijtmans und C. Willis: "A 5V complementary-SiGe BiCMOS technology for high-speed precision analog circuits", BCTM, pp. 211-214, 2003, veröffentlicht (nachfolgend El-Kareh et al.). Die dort beschriebene Lösung zielt auf möglichst geringe parasitäre Kapazitäten und einen möglichst geringen Kollektorwiderstand. Kleine Kollektor-Substratkapazitäten werden mit Hilfe tiefer, mit Isolatormaterial verfüllter Gräben (engl.: "deep trenches") sowie mit einer vergrabenen Oxidschicht in SOI-Technologie (engl.: "silicon on insulator") realisiert. Außerdem sichert die vergrabene Oxidschicht in Verbindung mit den tiefen Gräben die elektrische Isolation der Kollektoren gegen das Substrat. Um Kollektorwiderstände klein zu halten, werden bei El-Kareh et al. epitaktisch vergrabene, hochdotierte Kollektorschichten sowie spezielle Implantationsschritte für einen niederohmigen Anschluss der vergrabenen Kollektorschichten, sogenannte "Collector Sinker", verwendet. El-Kareh et. al. erreichen mit dieser Technologie Grenzfrequenzen f_{T}/fₘₐₓ von 19/60 GHz für npn-Transistoren und 19/45 GHz für pnp-Transistoren.

Eine komplementäre Bipolar-Halbleitervorrichtung mit den Merkmalen des Oberbegriffs des Anspruchs 1 ist aus JP 2000 188296 bekannt.

Die oben beschriebene Verwendung tiefer Isolationsgräben ist dagegen auch aus den Dokumenten US 2003/146468 A1, US 2003/162360 A1, US 2003/146477 A1 und US 2003/219952A1 bekannt.

Nachteil dieses Verfahrens ist jedoch, dass typische moderne CMOS-Technologien weder epitaktisch vergrabene Kollektorschichten noch tiefe Isolationsgräben oder Collektor Sinker enthalten. Der Prozessaufwand für diese Prozessschritte ist zum Teil erheblich. Da die CMOS-Transistoren in die Epitaxieschicht, die über den vergrabenen Kollektorschichten abgeschieden wird, eingebracht werden, ist eine zusätzliche Wärmebelastung der von El-Kareh et al. verwendeten vergrabenen Kollektorschichten während des CMOS-Prozesses nicht zu vermeiden. Dies verringert die Profilsteilheit der vergrabenen Kollektorschichten, wodurch die Leistungsfähigkeit beider Bipolartransitortypen, insbesondere jedoch die der pnp-Transistoren im Hochgeschwindigkeitsbereich beeinträchtigt wird.

Weiterhin hat das von El-Kareh et. al. beschriebene Verfahren den Nachteil, dass Prozessschritte für CMOS- und Bipolarbauelemente gekoppelt werden. So wird ein Gate-Polysilizium-Schichtstapel erzeugt, der aus zwei Polysiliziumabscheidungen resultiert. Die zweite Polysiliziumschicht entsteht während der Abscheidung der Basis der npn-Bipolartransistoren als p-dotierte polykristalline SiGe-Schicht. Damit soll das Ziel verfolgt werden, den Prozessaufwand und somit die Komplexität und den Kostenaufwand der vorgeschlagenen komplementären BiCMOS-Technologie gering zu halten. Der Nachteil dieses Verfahrens ist jedoch, dass auf diese Weise die überlicherweise angestrebte Austauschbarkeit von Prozessmodulen, beispielsweise die Ersetzung einer veralteten CMOS-Generation durch eine neue, behindert wird.

Wie oben erwähnt, bietet weiterhin zwar die Verwendung eines SOI-Substrates in Kombination mit "Deep Trenches" den Vorteil, ohne weitere technologische Aufwendungen eine elektrische Isolation der Bipolartransistoren zu ermöglichen. Außerdem kann die Kollektor-Substrat-Kapazität vergleichsweise klein gehalten werden. SOI-Substrate haben jedoch insbesondere den Nachteil, dass die Abführung der beim Transistorbetrieb entstehenden Wärme im Vergleich zu Standardsubstraten erheblich erschwert ist. Dieser Nachteil bewirkt eine zusätzliche Selbstaufheizung der Transistoren unter den Betriebsbedingungen im Hochgeschwindigkeitsbereich und führt damit zu einer Verringerung des Leistungspotentials.

Ferner sind die bei El-Kareh et. al. vorhandenen Si-Schichten auf der vergrabenen Oxidschicht des SOI-Substrates in der vertikalen Ausdehnung zu mächtig, um ohne Schwierigkeiten optimierte MOS-Transistoren, z.B. sogenannte "fully depleted MOS-Transistoren", auf SOI-Substrat herstellen zu können. Die Integration der komplementären Bipolartransistoren mit einer CMOS-Technologie, die für Standard-Substrate entwickelt wurde, erfordert allein wegen des Übergangs auf SOI-Substrat zusätzliche Aufwendungen.

In der Publikation von M.C. Wilson, P.H. Osborne, S. Nigrin, S.B. Goody, J. Green, S.J. Harrington, T. Cook, S.Thomas, A.J. Manson, A. Madni:"Process HJ: A 30GHz NPN and 20GHz PNP complementary bipolar process for high linearity RF circuits", S. 164-167, BCTM 1998, wird auf die Verwendung eines SOI-Substrates verzichtet und die elektrische Isolation der Bipolartransistoren in vertikaler Richtung mit Hilfe einer speziellen Isolationsdotierung erreicht. Für die laterale Isolation werden "Deep Trenches" verwendet.

Die von Wilson et al. vorgestellte Anordnung hat jedoch den entscheidenden Nachteil, dass sowohl die vertikale als auch die laterale Grenzfläche zwischen Kollektor bzw. Kollektoranschlussgebiet und der speziellen Isolationsdotierung zur parasitären Kollektorkapazität des pnp-Transistors beitragen. Aufgrund der hohen parasitären Kollektorkapazität ist der Transistor von Wilson et al. daher für eine Verbesserung der Hochgeschwindigkeitsparameter ungeeignet. Weiterhin benötigt die spezielle, von Wilson et al. verwendete Dotierung einen zusätzlichen Maskenschritt.

Schließlich werden bei Wilson et al., ebenso wie bei El-Kareh et. al., epitaktisch vergrabene Kollektorschichten und Sinker-Dotierungen für den Kollektoranschluss eingesetzt, wodurch sich die oben angegebenen Nachteile für eine CMOS-Integration ergeben. Das betrifft insbesondere den Umstand, dass die epitaktisch vergrabenen Kollektoren im Prozessablauf vor den Feldisolations- und Wannengebieten der CMOS-Transistoren gefertigt werden müssen und damit die Realisierung steiler Profile stark behindert wird. In diesem Zusammenhang ist zu erwähnen, dass eine Integration der beschriebenen komplementären Bipolartransistoren in einem CMOS-Prozess nicht Gegenstand der Arbeit von Wilson et al. ist.

Das der Erfindung zugrunde liegende technische Problem ist es daher, eine komplementäre Bipolar-Halbleitervorrichtung der eingangs genannten Art anzugeben, bei der beide Bipolartransistortypen günstige Eigenschaften für Hochgeschwindigkeitsanwendungen aufweisen. Ein weiteres, der Erfindung zugrunde liegendes technisches Problem ist es, ein Verfahren zur Herstellung einer Bipolar-Halbleitervorrichtung anzugeben, mit dem die beschriebenen Nachteile bekannter Verfahren insbesondere im Hinblick bei der Integration der Herstellung der komplementären Bipolartransistoren in einer CMOS-Technologie vermieden werden können.

Gemäß einem ersten Aspekt der Erfindung wird das technische Problem gelöst durch eine komplementäre Bipolar-Halbleitervorrichtung
- mit einem Substrat eines ersten Leitfähigkeitstyps und einer Anzahl darauf vorgesehener aktiver Gebiete, die in lateraler Richtung von flachen Feldisolationsgebieten begrenzt werden,
- bei der in einer ersten Teilanzahl der aktiven Gebiete vertikale npn-Bipolartransistoren mit epitaxialer Basis, und in einer zweiten Teilanzahl der aktiven Gebiete vertikale pnp-Bipolartransistoren mit epitaxialer Basis angeordnet sind,
- wobei entweder ein Transistortyp oder beide Transistortypen in ein und demselben jeweiligen aktiven Bipolartransistorgebiet sowohl ein Kollektorgebiet als auch ein Kollektorkontaktgebiet aufweisen.

Bei der erfindungsgemäßen komplementären Bipolar-Halbleitervorrichtung ist ausschließlich bei einem ersten Transistortyp, bei dem der Leitfähigkeitstyp des Substrates mit dem des Kollektorgebiets übereinstimmt, ein Isolationsdotierungsgebiet zwischen Kollektorgebiet und Substrat vorgesehen. Das Isolationsdotierungsgebiet ist ausgebildet, eine elektrische Isolation von Kollektor und Substrat zu bewirken.

Im ersten Transistortyp ist erfindungsgemäß im Bereich einer Grenzfläche zwischen dem Kollektorgebiet und dem Isolationsdotierungsgebiet ein p-n-Übergang ausgebildet, der am durch die Feldisolationsgebiete definierten seitlichen Rand des betreffenden aktiven Bipolartransistorgebiets, alternativ im gesamten jeweiligen aktiven Bipolartransistorgebiet nicht tiefer angeordnet ist als die Unterkante der flachen Feldisolationsgebiete.

Weiterhin ist erfindungsgemäß das Kollektorgebiet entweder des ersten Transistortyps oder beider Transistortypen lateral durch die flachen Feldisolationsgebiete begrenzt.

Nachfolgend werden zunächst einige zur Beschreibung des erfindungsgemäßen Transistors verwendete Begriffe näher erläutert.

Die erfindungsgemäße komplementäre Bipolar-Halbleitervorrichtung wird im Rahmen dieser Anmeldung auch kurz als CBi-Halbleitervorrichtung bezeichnet. Unter einem aktiven Bipolartransistorgebiet ist der sich im Querschnittsprofil zwischen zwei benachbarten Feldisolationsgebieten erstreckende halbleitende Substratbereich zu verstehen, in dem die wesentlichen funktionellen Strukturelemente des Bipolartransistors, nämlich Basis, Emitter und Kollektor angeordnet sind.

Ein aktives Bipolartransistorgebiet ist ein Spezialfall eines aktiven Gebiets. Unter einem aktiven Gebiet wird allgemein ein sich im Querschnittsprofil zwischen zwei benachbarten Feldisolationsgebieten erstreckender halbleitender Substratbereich verstanden, in dem funktionelle Strukturelemente der CBi-Halbleitervorrichtung angeordnet sind.

Als Beispiel zur Unterscheidung der beiden Begriffe "aktives Bipolartransistorgebiet" und "aktives Gebiet" sei auf das Beispiel des Kollektorkontaktgebietes der erfindungsgemäßen CBi-Halbleitervorrichtung hingewiesen. Es ist bei einem Transistortyp in demselben aktiven Bipolartransistorgebiet angeordnet wie der Kollektor. Dagegen kann es beim anderen Transistortyp auch in einem anderen aktiven Gebiet angeordnet sein. Dieses andere aktive Gebiet in diesem Fall ist jedoch kein aktives Bipolartransistorgebiet, weil es nicht Basis, und Emitter und Kollektor des betreffenden Bipolartransistors enthält.

Der in der CMOS-Techologie übliche Begriff des flachen Feldisolationsgebiets bezeichnet ein grabenförmiges Isolationsgebiet, das annähernd bündig mit der Substratoberfläche abschließt und in Richtung des Substratinneren eine Tiefenerstreckung von typischerweise 300 bis 600 nm hat. Flache Feldisolationsgebiete werden typischerweise seit Einführung der 0,25 µm-CMOS-Technologie mit der so genannten "Shallow-Trench"-Technologie hergestellt. Die Gräben der flachen Feldisolationsgebiete können beispielsweise mit Siliziumdioxid oder mit einer Kombination mehrerer Isolatormaterialien verfüllt sein.

Im folgenden werden die Merkmale und Vorteile der erfindungsgemäßen CBi-Halbleitervorrichtung näher erläutert.

Im Gegensatz zu bekannten, hinsichtlich ihrer Hochfrequenztauglichkeit optimierten komplementären Bipolar-Halbleitervorrichtungen gelingt mit der erfindungsgemäßen CBi-Halbleitervorrichtung auf einfache Weise die Integration der Herstellung beider Bipolartransistortypen mit besonders guten Hochfrequenzeigenschaften in einen CMOS-Prozess.

Die Integration beider Transistortypen in einen CMOS-Prozess wird erfindungsgemäß dadurch erleichtert, dass bei demjenigen Transistortyp, bei dem der Leitfähigkeitstyp des Kollektorgebiets mit dem des Substrats übereinstimmt, ein Isolationsdotierungsgebiet zwischen Kollektorgebiet und Substrat angeordnet ist, welches die vertikale Isolation dieses Transistortyps herstellt, wobei eine vertikale Isolation als Isolation zu den in Richtung des Substratinneren gelegenen Substratgebieten zu verstehen ist.

Der Transistortyp, bei dem der Leitfähigkeitstyp des Kollektorgebiets mit dem des Substrats übereinstimmt, wird hier auch als "erster Transistortyp" oder "erster Bipolartransistortyp" bezeichnet. Ist beispielsweise das Substrat p-leitend, so ist der erste Transistortyp ein pnp-Transistor.

Die erforderliche laterale Isolation des Kollektors dieses Bipolartransistortyps oder beider Bipolartransistortypen wird erfindungsgemäß von flachen Feldisolationsgebieten, insbesondere Feldisolationsgebieten der MOS-Technologie übernommen. Die flachen Feldisolationsgebiete übernehmen in der erfindungsgemäßen CBi-Halbleitervorrichtung somit neben der Abgrenzung aktiver Gebiete von umgebenden Substratbereichen die laterale Isolation des Kollektors als zusätzliche Funktion. Die seitliche Begrenzung des Kollektorgebietes durch die Feldisolationsgebiete bewirkt geringe Kapazitätswerte zwischen dem Kollektor des jeweiligen Transistors und der seitlichen bzw. substratseitigen Umgebung. Geringe Kapazitätswerte fördern die Hochfrequenztauglichkeit der Bipolartranistoren.

Erfindungsgemäß ist weiterhin im ersten Transistortyp im Bereich einer Grenzfläche zwischen dem Kollektorgebiet und dem Isolationsdotierungsgebiet ein p-n-Übergang ausgebildet, der am durch die Feldisolationsgebiete definierten Rand des betreffenden aktiven Bipolartransistorgebiets, alternativ im gesamten jeweiligen aktiven Bipolartransistorgebiet nicht tiefer angeordnet ist als die Unterkante der flachen Feldisolationsgebiete. Die geringe laterale Ausdehnung des Kollektorgebietes verringert den Kollektorwiderstand. Weiterhin wird mit dieser Maßnahme eine geringe Fläche der Raumladungszone zwischen dem Kollektorgebiet und dem Isolationsdotierungsgebiet ermöglicht, wodurch sich die Kollektor-Substrat-Kapazität weiter verringert. Wesentlich ist hierfür die laterale Begrenzung des p-n-Übergangs durch die flachen Feldisolationsgebiete.

In der ersten genannten alternativen Ausführungsform ist der p-n-Übergang am durch die Feldisolationsgebiete definierten Rand des betreffenden aktiven Gebiets nicht tiefer angeordnet ist als die Unterkante der flachen Feldisolationsgebiete. Das heißt, dass der p-n-Übergang zwischen dem Kollektorgebiet und dem Isolationsdotierungsgebiet zur Mitte des aktiven Gebietes hin auch tiefer, also weiter zum Substratinneren hin angeordnet sein kann als die Unterkante der Feldisolationsgebiete. Der p-n-Übergang kann beispielsweise die Form einer auf den Kopf gestellten Glocke haben.

In der zweiten genannten Ausführungsform dieses Ausführungsbeispiels ist der p-n-Übergang jedoch über die gesamte laterale Erstreckung des aktiven Gebiets in einer Tiefe angeordnet, die nicht über die der Feldisolationsgebiete am Rand des aktiven Gebietes hinausreicht. Bei dieser Ausführungsform sind die Kapazitätswerte besonders gering, was besonders vorteilhaft für die Hochgeschwindigkeitsparameter des ersten Transistortyps ist.

Das Merkmal der Isolationsdotierung und das Merkmal der lateralen Isolation durch die flachen Feldisolationsgebiete bilden jeweils selbstständig schutzwürdige Erfindungen, die auch unabhängig von einander in einem Bipolartransistor verwirklicht werden können. Das Isolationsdotierungsgebiet stellt in vertikaler Richtung die elektrische Isolation des Kollektors des ersten Bipolartransistortyps zum Substrat her. Die Feldisolationsgebiete bewirken eine laterale Isolation des Kollektors. Beide Merkmale können grundsätzlich mit jeweils anderen, für die vertikale bzw. laterale Isolation des Kollektors vorbekannten Isolationslösungen kombiniert werden. Besonders vorteilhaft ist jedoch die Wirkung dieser beiden Merkmale in Kombination in der vorliegend beanspruchten Erfindung.

Es ist bei der erfindungsgemäßen CBi-Halbleitervorrichtung nicht erforderlich, den ersten Bipolartransistortyp in einer Epitaxieschicht, die vor den wesentlichen Fertigungsprozessen für MOS-Transistoren abgeschieden wird, und über einer zuvor mit einem Extra-Maskenschritt dotierten Wanne anzuordnen, wie es bei bekannten BiCMOS-Prozessen der Fall ist. Auch die aufwändige Herstellung einer vergrabenen Oxidschicht und tiefer, mit Oxid verfüllter Gräben zur Isolation der Kollektorgebiete vom Substrat ist auf diese Weise überflüssig.

Insbesondere ermöglicht die erfindungsgemäße Anordnung die Herstellung hochleitfähiger und kapazitätsarmer Kollektorgebiete auch nach Fertigstellung wesentlicher Elemente einer MOS-Technologie, wie Fertigung der Feldisolation, der Wannengebiete und der MOS-Gates. Dadurch werden die Kollektorgebiete im weiteren Verlauf des Herstellungsprozesses einer besonders geringen thermischen Belastung ausgesetzt. So kann die Steilheit der Kollektor-profile, die nach der Implantation anzutreffen ist, während der restlichen Prozessschritte eines CBiCMOS-Prozesses bewahrt werden. Somit werden bessere Voraussetzungen für Hochfrequenztransistoren in einer CBiCMOS-Technologie geschaffen.

Wichtig für den Einsatz der erfindungsgemäßen Anordnung in Schaltungen ist die Realisierung defektarmer, hochdotierter Kollektorgebiete. Bisher im Rahmen der BiCMOS-Technologie angewandte Methoden zur Erzeugung defektarmer, hochdotierter Gebiete erfordern Wärmebehandlungen bei Temperaturen, die die Eigenschaften von Wannenprofilen der MOS-Transistoren oder Basisprofilen der Bipolartransistoren nachteilig beeinflussen können. Dies wird bei der Herstellung der erfindungsgemäßen CBi-Halbleitervorrichtung vermieden durch gezielt eingesetzte, amorphisierende Implantationen. Diese sichern eine defektarme Ausheilung der Implante bei ausreichend niedrigen Temperaturen.

Die Anordnung von Kollektorgebiet und Kollektorkontaktgebiet in ein und demselben aktiven Gebiet bei der erfindungsgemäßen CBi-Halbleitervorrichtung ermöglicht auf einfache, aber sehr wirkungsvolle Weise die Erzielung geringer Kollektorwiderstände und Kollektor-Substrat-Kapazitäten. Weiterhin ist die Verwendung einer epitaxialen Basis in den Bipolartransistortypen für die Erzielung guter Hochfrequenzeigenschaften förderlich.

Die erfindungsgemäße Vorrichtung kann ohne Nachteile für die beteiligten Transistormodule auf SOI-Substraten mit sehr dünnen Si-Deckschichten hergestellt werden, die insbesondere Schichtdicken von weniger als 50 nm haben können. Insbesondere entfällt die bei bekannten Anordnungen durch vergrabene Oxidschichten verschlechterte Wärmeabfuhr. Auch die Vergrößerung der Dicke der Si-Deckschichten während der Herstellung epitaktisch vergrabener Kollektoren tritt bei der erfindungsgemäßen Vorrichtung nicht auf. Daher kann die erfindungsgemäße Vorrichtung leicht mit so genannten "Fully Depleted"-MOS-Transistoren kombiniert werden.

Die erfindungsgemäße CBi-Halbleitervorrichtung wurde bereits im Rahmen einer CBiCMOS-Technologie mit pnp-Transistoren hergestellt, die f_{T}/fₘₐₓ-Werte von 80 GHz/120 GHz und npn-Bipolartransistoren mit Werten von 180 GHz/185 GHz aufweisen. Dies ist eine Verbesserung gegenüber dem derzeit bekannten Stand der Technik um einen Faktor von etwa 2.

Nachfolgend werden Ausführungsbeispiele der erfindungsgemäßen CBi-Halbleitervorrichtung beschrieben.

In einem Ausführungsbeispiel werden die Hochgeschwindigkeitsparameter des ersten Transistortyps durch eine geringe Konzentration der Isolationsdotierung im Raumladungsgebiet in Richtung Kollektor, das heißt nahe am Kollektor, weiter verbessert. Generell ist in diesem Zusammenhang unter der Angabe "in Richtung Kollektor" oder "kollektornah" ein Bereich zu verstehen, der zwischen 0,05 µm und 2 µm Abstand vom Kollektor hat. Dabei hängt es jedoch von der Höhe Dotierstoffkonzentration ab, was im Einzelfall unter kollektornah zu verstehen ist. Dies wird nachfolgend erläutert.

Ein Dotierungsprofil der Isolationsdotierung dieses Ausführungsbeispiels, in dem die Konzentration des zur Isolationsdotierung verwendeten Dotierstoffes als Funktion der Position im Substrat zwischen Kollektor und dem substratseitigen pn-Übergang der Isolationsdotierung aufgetragen ist, zeigt eine geringe Konzentration in Richtung Kollektor. Folgende Beispiele zeigen den Zusammenhang zwischen der Höhe der Dotierstoffkonzentration und der Ausdehnung des kollektornahen Gebiets: Die Dotierstoffkonzentration dieses kollektornahen Gebietes ist vorzugsweise kleiner als 1 x 10¹⁷ cm⁻³. Das kollektornahe Gebiet umfasst dabei einen Bereich mit einem Abstand zwischen 0,1 µm und 0,5 µm vom Kollektor. In einem weiteren Ausführungsbeispiel beträgt die Dotierstoffkonzentration des kollektornahen Gebiets eingeschränkt maximal 1 x 10¹⁶ cm⁻³. Das kollektornahe Gebiet umfasst dabei einen Bereich mit einem Abstand zwischen 0,2 und 1 µm vom Kollektor. In einem anderen Ausführungsbeispiel beträgt die Dotierstoffkonzentration des kollektornahen Gebiets weiter eingeschränkt weniger als 1 x 10¹⁵ cm⁻³. Das kollektornahe Gebiet umfasst dabei einen Bereich mit einem Abstand zwischen 0,4 und 2 µm vom Kollektor. Zum substratseitigen pn-Übergang hin kann die Dotierstoffkonzentration zunehmen. Mit den genannten Beispielprofilen gelingt es, besonders niedrig Kapazitätswerte und damit besonders gute Hochfrequenzeigenschaften zu erzielen.

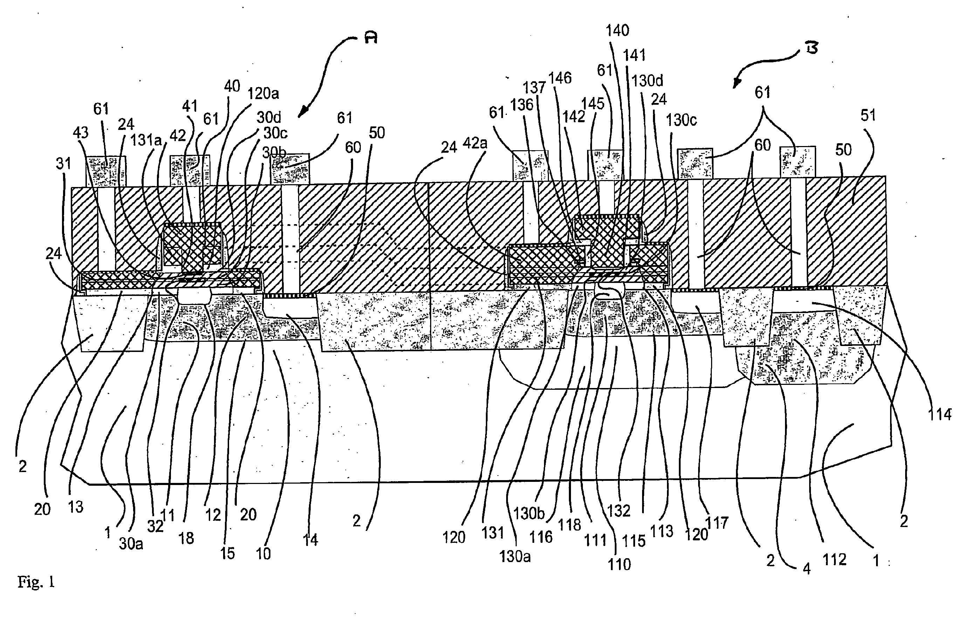

Bei einem besonders bevorzugten Ausführungsbeispiel der erfindungsgemäßen CBi-Halbleitervorrichtung sind im ersten Transistortyp benachbarten aktiven Gebiet eine Wanne des dem ersten Leitfähigkeitstyp entgegengesetzten, zweiten Leitfähigkeitstyps und ein ihr zugeordnetes Kontaktgebiet des zweiten Leitfähigkeitstyps vorgesehen. Zur Veranschaulichung dieses Ausführungsbeispiels wird vorab auf Figur 1 verwiesen. Dort ist die Wanne mit Bezugszeichen 4 und das Kontaktgebiet mit Bezugszeichen 112 eingezeichnet. Mit Hilfe dieser Struktur gelingt es, den Anschlusswiderstand der Isolationsdotierung gering zu halten. Die Verringerung des Anschlusswiderstandes der Isolationsdotierung bewirkt eine weitere Verbesserung der Hochfrequenzeigenschaften des ersten Transistortyps. In einer bevorzugten Ausführungsform ist die Wanne eine Wanne des zweiten Leitfähigkeitstyps. Insbesondere kann es sich bei der Wanne um eine in einem MOS-Prozess hergestellte Wanne handeln.

Die Kollektordotierung wird bevorzugt so gewählt, dass ein geringer Kollektorwiderstand resultiert. Die Implantationsdosis kann im Bereich von 1 x 10¹³ cm⁻² bis 8 x 10¹⁵ cm⁻², vorzugsweise zwischen 2,5 x 10¹⁴ cm⁻² bis 5 x 10¹⁵ cm⁻², eingeschränkt zwischen 2,5 x 10¹⁴ cm⁻² bis 1 x 10¹⁵ cm⁻² und noch weiter eingeschränkt zwischen 2,5 x 10¹⁴ cm⁻² bis 5 x 10¹⁴ cm ⁻² liegen. Ein zweiter bevorzugter Dosisbereich liegt zwischen 1 x 10¹⁵ cm⁻² bis 5 x 10¹⁵ cm⁻². Um einen geringen Kollektorwiderstand zu erzielen, ist außerdem ein möglichst abrupter Anstieg der Dotierung des Kollektorgebietes auf der emitterseitigen Flanke des Profils vorteilhaft. Das Dotierungsprofil des Kollektorgebietes ist dabei bevorzugt so gestaltet, dass nach allen Diffusionsschritten an der basisseitigen Flanke die Konzentration innerhalb von weniger als 150 nm mindestes um zwei Größenordnungen, vorzugsweise innerhalb von weniger als 80 nm um mindestens zwei Größenordnungen, noch weiter eingeschränkt innerhalb von weniger als 40 nm um mindestens zwei Größenordnungen zunimmt. Beispielsweise kann die Kollektordotierung von einem Referenzniveau von mindestens 1 x 10¹⁷ cm⁻³ ausgehend zunehmen. Die Zunahme der Dotierstoffkonzentration um mindestens zwei Größenordnungen über die angegebenen Tiefenbereiche erfolgt vorzugsweise in der Art, dass der hiermit ausgezeichnete Abschnitt des Kollektorprofils an der kollektorseitigen Basisgrenze beginnt.

Die Dotierstoffdosis der Wanne beträgt vorzugsweise zwischen 5 x 10¹² cm⁻² und 5 x 10¹⁴ cm⁻², besonders bevorzugt zwischen 1 x 10¹³ cm⁻² und 2 x 10¹⁴ cm⁻².

Die Dotierstoffkonzentration des Kontaktgebiets beträgt vorzugsweise zwischen 1 x 10¹⁷ cm⁻³ und1 x 10²¹ cm⁻³.

Eine weitere Reduzierung des Widerstandswertes gelingt in einem Ausführungsbeispiel, bei dem die Wanne und das Kontaktgebiet das Isolationsdotierungsgebiet lateral an zwei, alternativ drei, alternativ vier Seiten umgeben.

Eine weitere Optimierung der Hochfrequenzeigenschaften beider Transistortypen gelingt durch eine besondere Ausbildung der Kollektordotierung. Die maximale Dotierstoffkonzentration im Kollektorkontaktgebiet des ersten Transistortyps beträgt vorzugsweise zwischen 1 x 10¹⁸ cm⁻³ und 5 x 10²⁰ cm⁻³. Die gleiche maximale Dotierstoffkonzentration wird vorzugsweise im Kollektorkontaktgebiet des zweiten Transistortyps angewendet.

Der erste oder der zweite Transistortyp oder beide Transistortypen weisen vorzugsweise eine SIC-Dotierung auf. Ein inneres Basisgebiet des jeweiligen Transistors definiert eine laterale Ausdehnung, mit der unterhalb ein zweites Kollektorgebiet angeordnet ist (auch SIC-Dotierung genannt) welches bei gleichem Leitfähigkeitstyp höher dotiert ist als zumindest ein an das zweite Kollektorgebiet angrenzender Bereich des Kollektorgebietes.

Auch die Basis kann mit Blick auf die Hochfrequenztauglichkeit weiter optimiert werden. In einer bevorzugten Ausführungsform weist die epitaxiale Basis einen Basisschichtstapel mit einer Mehrzahl Schichten auf, die im inneren Basisgebiet einkristallin und in Abschnitten, die in lateraler Richtung außerhalb des inneren Basisgebiets liegen und nachfolgend als Basiskontaktgebiet bezeichnet werden, polykristallin ausgebildet sind. Die Herstellung dieser Schichtstruktur erfolgt beispielsweise zunächst mittels selektiver Epitaxie in einem Fenster über dem Kollektorgebiet und anschließend mittels differentieller Epitaxie.

Eine im Basisschichtstapel vorgesehene funktionelle Basisschicht kann besonders vorteilhaft entweder in Silizium oder in Silizium-Germanium eingebracht sein. Ist sie in Silizium eingebracht, weist sie vorzugsweise eine Dicke von zwischen 1 und 100 nm, insbesondere von zwischen 1 und 35 nm auf. Ist die funktionelle Basisschicht in Silizium-Germanium (SiGe) eingebracht, kann die Dicke der SiGe-Schicht zwischen 1 und 150nm, insbesondere zwischen 2 und 50nm liegen. Soweit in dieser Anmeldung die Formulierung "die Basisschicht" verwendet wird, ist die funktionelle Basisschicht gemeint, es sei denn, dass ausdrücklich etwas anderes gesagt wird.

Vorzugsweise enthält der Basisschichtstapel eine emitterseitig an die Basisschicht angrenzende Deckelschicht.

Besonders bevorzugt ist eine oder sind mehrere der Schichten des Basisschichtstapels mit Kohlenstoff dotiert. Auf diese Weise kann die Dotierstoffkonzentration in den kohlenstoffdotierten Schichten erhöht werden, was eine Verringerung des Widerstandes bewirkt und die Hochfrequenzeigenschaften beider Bipolartransitortypen fördert.

Der erste, der zweite oder beide Transistortypen können einen T-förmigen Emitter enthalten. Eine besonders vorteilhafte, weil einfach herzustellende Ausführungsform sieht vor, dass ein im Basisschichtstapel des ersten Transistortyps vorgesehener substratseitiger Abschnitt des Basiskontaktgebiets aus demselben, gleichzeitig abgeschiedenen polykristallinen Halbleitermaterial gefertigt ist wie ein basisseitiger, äußerer Abschnitt des T-Querbalkens des Emitters im zweiten Transistortyp.

Eine weitere Vereinfachung erfolgt dadurch, dass ein im Basisschichtstapel des ersten Transistortyps vorgesehener emitterseitiger vertikaler Schichtabschnitt des Basiskontaktgebiets aus demselben, gleichzeitig abgeschiedenen polykristallinen Halbleitermaterial gefertigt ist wie ein kontaktseitiger vertikaler Schichtabschnitt des T-Querbalkens des Emitters im zweiten Transistortyp.

Die vorgenannten Ausführungsbeispiele bewirken, dass
- im ersten Transistortyp das polykristalline Basiskontaktgebiet im Basisschichtstapel eine parallel zur Substratoberfläche verlaufende Grenzfläche aufweist, entlang welcher Korngrenzen der hier aneinander grenzenden, basisseitigen und emitterseitigen, polykristallinen, vertikalen Schichtabschnitte ausgerichtet sind, und dass
- im zweiten Transistortyp der Emitter eine parallel zur Substratoberfläche verlaufende Grenzfläche aufweist, entlang welcher Korngrenzen in den hier aneinander grenzenden, basisseitigen und kontaktseitigen, polykristallinen, vertikalen Schichtabschnitten ausgerichtet sind.

Vorzugsweise haben die flachen Feldisolationsgebiete die Form flacher Gräben (engl.: shallow trench). Alternativ können die Feldisolationsgebiete auch mit Hilfe von LOCOS-Isolation oder anderer bekannter Verfahren hergestellt sein.

Ein besonders bevorzugtes Ausführungsbeispiel der Erfindung ist eine CBiMOS- oder CBiCMOS-Halbleitervorrichtung. Das heißt, die CBi-Halbleitervorrichtung weist mindestens ein MOS-Halbleiterbauelement oder komplementäre MOS-Halbleiterbauelemente auf.

Bei einer weiteren bevorzugten Ausführungsform ist das Substrat p-leitend und der erste Transistortyp ein pnp-Transistor und der zweite Transistortyp ein npn-Transistor.

Gemäß einem zweiten Aspekt der Erfindung wird die Aufgabe gelöst durch ein Verfahren zur Herstellung komplementärer, hochfrequenztauglicher Bipolartransistoren im Rahmen eines CMOS-Prozesses und in einer Halbleitervorrichtung gemäß dem ersten Aspekt der Erfindung,
- bei dem die Schichten beider Bipolartransistortypen in einem in den CMOS-Prozess eingefügten Bipolar-Verfahrensmodul auf aktiven Gebieten eines durch flache Feldisolationsgebiete vorstrukturierten Substrates eines ersten Leitfähigkeitstyps abgeschieden und strukturiert werden,

- bei dem bei einem oder beiden Bipolartransistortypen ein Kollektorgebiet und ein Kollektorkontaktgebiet innerhalb ein und desselben aktiven Gebiets ausgebildet werden,
- bei dem bei demjenigen Bipolartransistortyp, dessen Kollektorgebiet denselben Leitfähigkeitstyp aufweist wie das Substrat, in einem Implantationsschritt ein Isolationsdotierungsgebiet unterhalb des Kollektorgebiets erzeugt wird, derart, dass das Kollektorgebiet vom Substrat elektrisch isoliert ist und
- bei dem der Implantationsschritt derart durchgeführt wird, dass im Bereich einer Grenzfläche zwischen dem Kollektorgebiet und dem Isolationsdotierungsgebiet ein p-n-Übergang ausgebildet ist, der am durch die Feldisolationsgebiete definierten Rand des betreffenden aktiven Bipolartransistorgebiets, alternativ im gesamten jeweiligen aktiven Bipolartransistorgebiet nicht tiefer angeordnet ist als die Unterkante der flachen Feldisolationsgebiete.

Mit dem erfindungsgemäßen Verfahren gelingt die Herstellung der CBi-Halbleitervorrichtung gemäß dem ersten Aspekt der Erfindung. Das Verfahren zeichnet sich durch eine vergleichsweise geringe Komplexität aus. Weiterhin ist das Bipolar-Verfahrensmodul unabhängig von einem sind der CMOS-Prozess. Daher können beide Verfahren leicht in einem CBiCMOS-Prozess integriert werden und auch unabhängig voneinander optimiert werden. Weitere Vorteile des erfindungsgemäßen Verfahrens ergeben sich aus der Darstellung der Vorteile der CBi-Halbleitervorrichtung gemäß dem ersten Aspekt der Erfindung.

Nachfolgend werden bevorzugte Ausführungsbeispiele des Verfahrens des zweiten Aspekts der Erfindung beschrieben.

Bei einem bevorzugten Ausführungsbeispiel des erfindungsgemäßen Verfahrens wird neben dem Implantationsschritt zur Erzeugung des Kollektorgebietes ein weiterer Implantationsschritt zur zumindest teilweisen Amorphisierung des Kollektorgebietes durchgeführt. Vorzugsweise wird nach den Implantationsschritten ein Schritt der Rekristallisation des Kollektorgebietes durchgeführt. Bei diesen Ausführungsbeispielen gelingt die Herstellung des Kollektorgebietes mit einer geringen Defektdichte. Der Schritt des Rekristallisierens wird vorzugsweise durch schnelles thermisches Ausheilen (engl.: rapid thermal annealing) bei ausreichend niedriger Temperatur durchgeführt.

Eine besonders einfache Realisierung des erfindungsgemäßen Verfahrens gelingt, wenn ein im Basisschichtstapel des ersten Transistortyps vorgesehener substratseitiger Schichtabschnitt des Basiskontaktgebiets gleichzeitig abgeschieden wird wie ein basisseitiger Schichtabschnitt des T-Querbalkens des Emitters im zweiten Transistortyp. Dabei kann sich ergeben, dass der entsprechende Schichtabschnitt des T-Querbalkens des Emitters eine Silizium-Germanium-Teilschicht enthält, weil dies im Basisschichtstapel des ersten Transistortyps so vorgesehen ist. Dies ist jedoch für die elektrischen Eigenschaften des Emitters des zweiten Transistortyps nicht nachteilig. Denn in einem nachfolgenden Verfahrensschritt wird dieser Emitterschichtabschnitt im Bereich des Emitterfensters geöffnet, so dass nur äußere Schichtabschnitte des Emitters aus diesem Material gefertigt sind. Diese haben keinen wesentlichen Einfluss auf die elektrischen Eigenschaften des Emitters des zweiten Transistortyps.

In einem weiteren Ausführungsbeispiel wird ein im Basisschichtstapel des ersten Transistortyps vorgesehener emitterseitiger Schichtabschnitt des Basiskontaktgebiets gleichzeitig abgeschieden wie ein kontaktseitiger Schichtabschnitt des T-Querbalkens des Emitters im zweiten Transistortyp. Auch mit dieser Maßnahme gelingt eine zusätzliche Vereinfachung des Bipolar-Verfahrensmoduls.

Das Bipolar-Verfahrensmodul wird vorzugsweise im Rahmen des CMOS-Prozesses im Anschluss an eine Gatestrukturierung und eine Bildung von Gate-Abstandshaltern und vor der Implantation von Source- und Draingebieten durchgeführt.

Das erfindungsgemäße Verfahren kann ohne Nachteile für die beteiligten Transistormodule auf SOI-Substraten, insbesondere SOI-Substraten mit sehr dünnen (beispielsweise <50nm) Si-Deckschichten hergestellt werden.

Weitere Merkmale und Vorteile der Erfindung ergeben sich aus der nachfolgenden Beschreibung von Ausführungsbeispielen anhand der Figuren. Es zeigen:
- Fig. 1: zeigt den Querschnitt der erfindungsgemäßen, komplementären Bi- polartransistoren.
- Fig. 2: zeigt den Querschnitt der erfindungsgemäßen, komplementären Bi- polartransistoren während der Herstellung in einem BiCMOS- Prozess.
- Fig. 3: zeigt den Querschnitt der erfindungsgemäßen, komplementären Bi- polartransistoren während der Herstellung in einem BiCMOS- Prozess.
- Fig. 4: zeigt den Querschnitt der erfindungsgemäßen, komplementären Bi- polartransistoren während der Herstellung in einem BiCMOS- Prozess.
- Fig. 5: zeigt den Querschnitt der erfindungsgemäßen, komplementären Bi- polartransistoren während der Herstellung in einem BiCMOS- Prozess.
- Fig. 6: zeigt den Querschnitt der erfindungsgemäßen, komplementären Bi- polartransistoren während der Herstellung in einem BiCMOS- Prozess.
- Fig. 7: zeigt den Querschnitt der erfindungsgemäßen, komplementären Bi- polartransistoren während der Herstellung in einem BiCMOS- Prozess.
- Fig. 8: zeigt den Querschnitt der erfindungsgemäßen, komplementären Bi- polartransistoren während der Herstellung in einem BiCMOS- Prozess.
- Fig. 9: zeigt den Querschnitt der erfindungsgemäßen, komplementären Bi- polartransistoren während der Herstellung in einem BiCMOS- Prozess.
- Fig. 10: zeigt den Querschnitt der erfindungsgemäßen, komplementären Bi- polartransistoren während der Herstellung in einem BiCMOS-Prozess auf SOI-Substratscheibe.
- Fig. 11: zeigt den Querschnitt der erfindungsgemäßen, komplementären Bi- polartransistoren während der Herstellung in einem BiCMOS-Prozess auf SOI-Substratscheibe.
- Fig. 12: zeigt den Querschnitt der erfindungsgemäßen, komplementären Bi- polartransistoren während der Herstellung in einem BiCMOS-Prozess auf SOI-Substratscheibe nach einem alternativen Verfahren.

Es werden nachfolgend unter Bezug auf die jeweils genannten Figuren vier Beispiele beschrieben.

### Beispiel 1:

Ein Ausführungsbeispiel der erfindungsgemäßen Halbleitervorrichtung, das komplementäre Bipolartransistoren mit epitaxialer Basis umfasst, wird nun in Bezug auf Fig. 1 erläutert. In diesem Beispiel sind ein npn-Bipolartransistor A und ein pnp-Bipolartransistor B auf einem hochohmigen, einkristallinen p-leitfähigen Si-Substrat 1 gefertigt. Die hier beschriebene Anordnung ist nicht auf p-leitfähige Si-Substrate beschränkt. Die wesentlichen Merkmale können auch auf Substrate vom entgegengesetzten Leitfähigkeitstyp übertragen werden. Außerdem können gleichzeitig CMOS-Transistoren auf dem Substrat 1 vorhanden sein, sind aber in Figur 1 nicht dargestellt.

Der npn-Bipolartransistor A mit epitaxialer Basis umfasst einen n-leitenden Kollektor 11 und einen ebenfalls n-leitenden Emitter 40. Der Kollektor ist seitlich über das Kollektorkontaktgebiet 12 und eine Kollektoranschlussdotierung 14 zum Kontakt geführt.

In vertikaler Richtung befindet sich zwischen Emitter 40 und Kollektor 11 ein einkristalliner Schichtstapel 30, der sich seitlich als polykristalliner Schichtstapel 31 fortsetzt. Der Schichtstapel 30 enthält eine p-leitende Basisschicht 30c. Eine innere Basisschicht 32 wird als Abschnitt der Basisschicht 30c in horizontaler Richtung etwa durch die Breite des Emitterfensters 41 definiert. Seitlich ist die innere Basisschicht 32 angeschlossen über einen einkristallinen Bereich der Basisschicht 30c und weiter außerhalb über die hoch leitfähige Schicht 31.

Eine erste Art Isolationsgebiete 2, im weiteren als flache Feldisolationsgebiete oder einfach nur als Feldisolationsgebiete bezeichnet, ragt von der Substratoberfläche aus ins Substratinnere hinein. Als Feldisolationsgebiete können sogenannte "Shallow-Trench" Isolationen eingesetzt werden. Dabei handelt es sich um vorzugsweise 300 bis 600nm tiefe Gräben, die z.B. mit Siliziumdioxid (SiO₂), aber auch mit einer Kombination aus Isolatormaterial und Polysilizium verfüllt sein können. Alternativ können auch mittels lokaler Oxidation (LOCOS) hergestellte Feldisolationsgebiete eingesetzt werden. Zusätzlich zu den flachen Feldisolationsgebieten sind auch tiefe, z.B. mit SiO₂ verfüllte Gräben, sogenannte "Deep-Trenches", nutzbar, die jedoch in der Anordnung gemäß Fig. 1 nicht vorgesehen sind.

Zwischen den Feldisolationsgebieten 2 sind an der Substratoberfläche Inseln einkristalliner Silizium-Gebiete, die sogenannten aktiven Gebiete vorhanden. In einem aktiven Bipolartransistorgebiet 10 ist der npn-Bipolartransistor mit epitaxialer Basis angeordnet. Er enthält einen im Substrat liegenden Kollektor 11, der seitlich von den Seitenwänden der Feldisolationsgebiete 2 begrenzt wird. Auf der Substratoberfläche sind Isolationsgebiete 2. Art 20 erzeugt. Hierbei handelt es sich um eine 1nm bis 150nm dicke, vorzugsweise 30 bis 150nm dicke SiO₂-Schicht. Es können aber auch Schichtstapel aus verschiedenen Isolatormaterialien, z.B. SiO₂-Schichten mit unterschiedlicher Ätzrate in verdünnter Flusssäure oder eine Kombination von SiO₂ und Siliziumnitrid Si₃N₄ verwendet werden. Die Isolationsgebiete 2. Art können auch mit einer leitfähigen Schicht, z.B. hochdotiertem Polysilizium bedeckt sein. Im Beispiel von Fig. 1 besteht das Isolationsgebiet 2. Art 20 aus 2 Teilgebieten. Eines davon liegt sowohl auf Feldisolationsgebiet 2 als auch auf aktivem Gebiet, das zweite liegt vollständig auf aktivem Gebiet.

Bedeckt ist der Kollektor des npn-Transistors 11 mit einem einkristallinen Schichtstapel 30, der in einem Epitaxieschritt erzeugt wird. Der Schichtstapel 30 setzt sich aus vier, nachfolgend beschriebenen Schichten 30a - 30d zusammen. Das Kollektorfenster 13 im Isolationsgebiet 2. Art über dem Kollektor 11 ist durch die einkristalline Si-Schicht 30a gefüllt. Sie kann eine Dicke von 20nm bis 150nm, vorzugsweise 30nm bis 100nm besitzen. Durch differentielles Wachstum entsteht die Pufferschicht 30b. Diese Schicht kann 5nm bis 70nm, vorzugsweise 10nm bis 50nm dick sein. Oberhalb der Pufferschicht ist die p-dotierte Basisschicht 30c erzeugt. Die Dicke der Basisschicht kann 5nm bis 100nm, vorzugsweise 5nm bis 35nm betragen. Über der Basisschicht folgt eine 10nm bis 100nm, vorzugsweise 20nm bis 50nm dicke Cap-Schicht 30d. Die Basis 30c kann vorzugsweise in eine Legierung von SiGe eingebracht werden. Außerdem kann in den Pufferschichten 30a,b oder in der Basisschicht 30c oder in der Cap-Schicht Kohlenstoff während der Epitaxie eingebaut worden sein.

Oberhalb des Schichtstapels 30, 31 befindet sich eine strukturierte Isolatorschicht 120a. Diese kann vorzugsweise aus einer 10nm bis 150nm, vorzugsweise aus 30 bis 120nm dicken SiO₂-Schicht bestehen. Sie kann aber auch aus einer Kombination verschiedener Isolatormaterialien zusammengesetzt sein.

Die Öffnung in der Isolatorschicht 120a über dem Schichtstapel 30 definiert das Emitterfenster 41. Zur Herstellung des Emitterfensters 41 ist mit Hilfe einer Lackmaske die Polysiliziumschicht 131a strukturiert worden. Diese sogenannte Hartmaske wird eingesetzt, um in einem Nassätzschritt das Emitterfenster in die Isolatorschicht 120a zu übertragen.

Eine hoch dotierte Siliziumschicht vom Leitungstyp des Kollektors, die npn-Emitterschicht 42, bedeckt das Emitterfenster 41 sowie die Polysiliziumschicht 131a. Die npn-Emitterschicht 42 kann als polykristallines, amorphes, partiell einkristallines, partiell polykristallines oder als einkristallines Material abgeschieden sein. Aus der hoch dotierten npn-Emitterschicht 42 kann während eines Hochtemperaturschrittes n-Dotierstoff in den Schichtstapel 30 durch das Emitterfenster 41 sowie in die Polysiliziumschicht 131a eindiffundiert sein. Der Emitter 40 umfasst in diesem Fall die npn-Emitterschicht 42, die Polysiliziumschicht 131a sowie das eindiffundierte n-Gebiet 43. Die resultierende seitliche Ausdehnung der npn-Emitterschicht 42 ist per Ätzung über eine Lackmaske vorzugsweise so gestaltet, dass die Seitenflächen der npn-Emitterschicht 42 über die inneren Seitenflächen der Isolationsgebiete 2. Art 20 seitlich hinausragen. Auf diese Weise kann nach der Ätzung der npn-Emitterschicht 42 eine Dotierung des Schichtstapels 31 vom Leitfähigkeitstyp der Basis per Implantation so erfolgen, dass die Ausläufer dieser Implantation vom Kollektor 11 ferngehalten werden. Per Lackmaske wird die Schicht 31 strukturiert. Anschließend werden die npn-Emitterschicht 42 sowie die Isolatorschichten 2. Art 20 und die Schicht 31 an den Seitenwänden mit einem Spacer, bestehend aus einer Doppelschicht SiO₂/Si₃N₄ 24 versehen.

Nach der Spacerbildung werden die mit einer vorzugsweise 1 nm bis 20nm SiO₂ Restschicht bedeckten aktiven Gebiete nasschemisch freigeätzt. In einem folgenden Silizierungsschritt entstehen die im Vergleich zu hochdotiertem Si noch besser leitfähigen Silizidschichten 50. Die Oberfläche der Transistorund Isolationsgebiete wird mit einer Isolatorschicht oder -schichtkombination 51 abgedeckt. Mit leitfähigem Material verfüllte Kontaktlöcher 60 und darüber liegende Metallstreifen 61 stellen den elektrischen Anschluss zu den Kontaktgebieten des Transistors her.

Der pnp-Bipolartransistor B mit epitaxialer Basis hat einen p-leitenden Kollektor 110 und einen ebenfalls p-leitenden Emitter 140. Der Kollektor 110 ist seitlich über ein Kollektorkontaktgebiet sowie eine Kollektoranschlussdotierung 117 zum Kollektorkontakt 60, 61 geführt.

Zwischen dem Kollektor 110 und dem Emitter 140 ist ein einkristalliner Schichtstapel angeordnet, der seitlich anschließend als polykristalliner Schichtstapel 131 fortgesetzt ist. Vom Kollektor ausgehend weist der einkristalline Schichtstapel eine einkristalline Si-Schicht 130a, eine Pufferschicht 130b, eine Basisschicht 130c sowie eine Deckelschicht 130d auf. Die Deckelschicht 130d wird auch als Cap-Schicht bezeichnet.

Die Basisschicht 130c ist n-leitend. Sie weist einen sich in lateraler Richtung etwa über die Breite des Emitterfensters 141 erstreckende innere Basisschicht 142 auf. Wie beim npn-Transistor A schließt sich an die innere Basisschicht 142 ein einkristalliner Bereich der Basisschicht 130c an, der in lateraler Richtung nach außen hin sich als hochleitfähige, polykristalline Basisanschlussschicht 131 fortsetzt.

Hinsichtlich der Schichtdicken der einzelnen Schichten des Schichtstapels 130 gilt das gleiche wie beim npn-Transistor A. Die Si-Schicht 130a kann eine Dicke von 20 nm bis 150 nm, vorzugsweise 30 nm bis 100 nm besitzen. Die mittels differentieller Epitaxie hergestellte Pufferschicht 130b hat eine Dicke zwischen 5nm und 70 nm, vorzugsweise zwischen 10 nm und 50 nm. Die Basisschicht 130c hat eine Schichtdicke zwischen 5 nm und 100 nm, vorzugsweise zwischen 5 nm und 35 nm. Die Cap-Schicht 130d hat eine Schichtdicke zwischen 10 nm und 100 nm, vorzugsweise zwischen 20 nm und 50 nm.

Die Basisschicht 130c des pnp-Transistors ist aus Si oder SiGe gefertigt. In den Pufferschichten 130a und 130b oder in der Basisschicht 130c oder in der Cap-Schicht 130d oder in mehreren dieser Schichten kann wie beim npn-Bipolartransistor A Kohlenstoff während der Epitaxie eingebaut worden sein.

Zu beachten ist, dass die im Basisschichtstapel 130 des pnp-Bipolartransistors B gegebene Materialfolge in Wachstumsrichtung in gleicher Weise im npn-Transistor A in äußeren Abschnitten 131a des Emitters vorliegt, da diese Funktionsschichten zugleich abgeschieden werden. Beim npn-Transistor A wird in einem nachfolgenden Schritt des Herstellungsverfahrens die Emitterschicht 131 a strukturiert und im Bereich des Emitterfensters mit Silizium aufgefüllt. Daher ist die Materialfolge des Basisschichtstapels 130 des pnp-Transistors B nur in den äußeren Schichtabschnitten des Emitters des npn-Transistors A wiederzufinden.

Im pnp-Transistor B ist oberhalb des Basisschichtstapels 130 der T-förmige Emitter 140 in einem durch laterale Abstandshalter (Spacer) 145 begrenzten Emitterfenster 141 abgeschieden. Der vertikale Abschnitt des T-förmigen Emitters 140 ist von einem erhöhten Basisanschlussgebiet 42a umgeben, das auf dem Basisschichtstapel 130 abgeschieden ist und zur Ausbildung des Emitterfensters lateral strukturiert wurde. Zur Isolierung des einkristallinen Bereiches des Basisschichtstapels 130 in unmittelbarer Nähe des Emitterfensters 141 ist eine zusätzliche Isolationsschicht 136 vorgesehen. Diese schließt lateral unmittelbar an die Spacer 145 an und erstreckt sich lateral mindestens teilweise über den einkristallinen Bereich des Schichtstapels 130. Eine Polysiliziumschicht 137 grenzt seitlich an den Spacer 145 und bedeckt Isolationsschicht 136. Die Polysiliziumschicht 137 ist eine Hilfsschicht, die der Strukturierung der Isolationsschicht 136 dient.

Zur Isolierung des Querbalkens des T-förmigen Emitters 141 vom Basisanschlussgebiet 42a ist eine Isolationsschicht 146 vorgesehen. Lateral ist der Querbalken an den Seitenwänden mit einem Spacer aus einer Doppelschicht SiO₂-Si₃N₄ 24 isoliert.

Der Kollektor 110 weist unterhalb des Emitterfensters eine SiC-Dotierung 118 auf, die sich auch in die Si-Schicht 130a hinein erstreckt.

Zur Isolierung des Kollektors 110 des pnp-Transistors B ist unterhalb des Kollektors ein Isolationsdotierungsgebiet 116 vorgesehen, das n-dotiert ist. Das Isolationsdotierungsgebiet 116 und der Kollektor 110 bilden einen pn-Übergang 115, der lateral durch die Feldisolationsgebiete 2 begrenzt ist, welche das aktive Gebiet des pnp-Transistors B definieren. Der pn-Übergang 115 befindet sich also in Richtung zum Substratinneren in geringerer Tiefe als der Boden der flachen Isolationsgebiete 2.

Die Kollektordotierung 115 ist in vergleichsweise geringer Tiefe vorgesehen. Dadurch wird die Kollektordotierung auf den innerhalb der Feldisolationsgebiete 2 liegenden Bereich lateral beschränkt. Auf diese Weise wird die parasitäre Kapazität zwischen Kollektor und Substrat aufgrund der geringen Fläche des pn-Übergangs zwischen Kollektordotierung 115 und der Isolationsdotierung 116 vergleichsweise klein gehalten. In Kombination mit Isolationsdotierung 116 sowie Wanne 4 und Kontaktgebiet 112 wird eine kapazitäts- und widerstandsarme Kollektoranordnung geschaffen, die der eingangs beschriebenen, vorbekannten SOI-Variante von El-Kareh et al. nicht nachsteht und die entsprechenden Eigenschaften der Vorrichtung von Wilson et al. deutlich verbessert. Dadurch werden im Ergebnis die Hochfrequenzeigenschaften des pnp-Transistors B deutlich verbessert.

Dem aktiven Bipolartransistorgebiet des pnp-Kollektors B auf der Seite des Kollektoranschlusses benachbart ist ein Kontaktgebiet in einem aktiven Gebiet mit vergleichsweise geringer lateraler Ausdehnung. Das Kontaktgebiet 112 hat eine n-dotierte Wanne 4 und ein nahe der Substratoberfläche vorgesehenes Dotierungsgebiet 114, das mit einer Silizidschicht 50 nach oben hin abgeschlossen ist. Mit Hilfe dieser Struktur gelingt es, den Anschlusswiderstand gering zu halten. Zusätzlich zu einer n-Wanne kann auch in dem bevorzugten Gebiet eine n-Dotierung, die in bestimmten CMOS-Technologien der elektrischen Isolation von n-MOS-Transistoren dient, Anwendung finden. Diese Zusatzdotierung ist nicht in Fig. 1 eingezeichnet.

Die gegenüber der Isolationsdotierung 116 flachere p-Dotierung 115 wird sowohl als Kollektor des pnp-Transistors als auch als niederohmiger Anschluss zum später entstehenden Kollektor-Kontaktgebiet genutzt.

Die Tiefe des Dotierungsprofils 115 ist so eingestellt, dass der pn-Übergang zur darunter liegenden n-Isolationsdotierung 116 nicht tiefer als die Unterkante der Feldisolationsgebiete 2 liegt. Mit Hilfe der n-Isolationsdotierung 116 wird der pnp-Transistor B elektrisch vom Substrat 1 isoliert.

Die seitliche Begrenzung der Dotierung 115 durch die Feldisolationsgebiete 2 und eine vorzugsweise geringe Maximalkonzentration der n-Isolationsdotierung 116 im Raumladungszonengebiet zum Kollektor sichert geringe Kapazitätswerte zwischen dem Kollektor des pnp-Transistors und der seitlichen bzw. substratseitigen Umgebung.

Zusätzlich ist ein geringer Anschlusswiderstand der n-Isolationsdotierung 116 anzustreben. Zu diesem Zweck wird seitlich ein n-Wannengebiet 4 mit dazugehörigem Kontaktgebiet 112 angeordnet. Eine zusätzliche Erniedrigung des Anschlusswiderstandes der n-Isolationsdotierung 116 lässt sich erreichen durch zwei-, drei- und vierseitige Umschließung der n-Isolationsdotierung 116 mit Hilfe des n-Wannengebietes 4 und entsprechenden Kontaktgebieten 112.

### Beispiel 2:

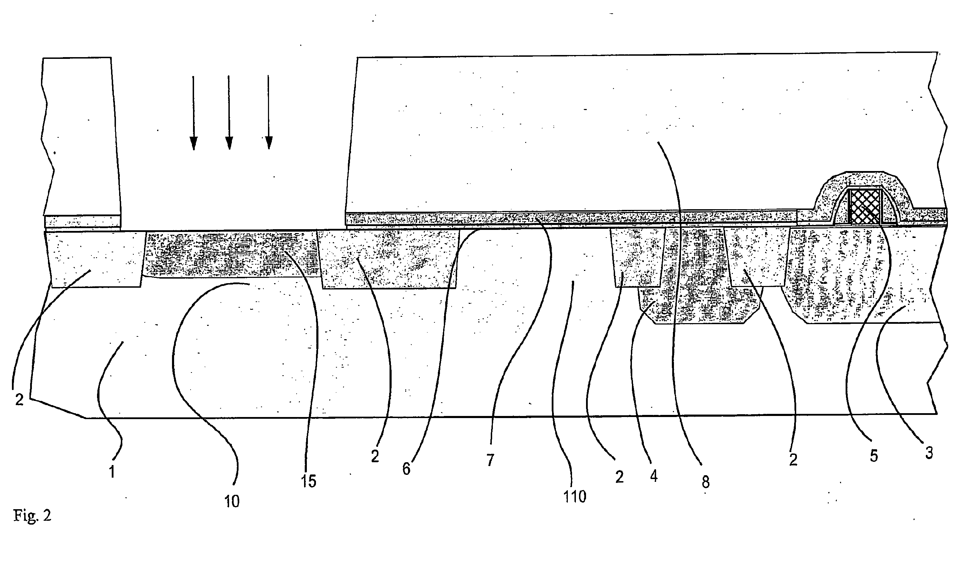

Es wird nun mit Bezug auf die Figuren 2 bis 8 ein Verfahren zur Herstellung der erfindungsgemäßen Halbleitervorrichtung, bestehend aus komplementären Bipolartransistoren mit epitaxialer Basis, erläutert. Außerdem werden im hier angegebenen Beispiel auf ein und derselben Substratscheibe neben komplementären Bipolartransistoren auch MOS-Transistoren erzeugt.

Fig. 2 zeigt eine Momentaufnahme während eines ersten Maskenschrittes zur Fertigung von komplementären Bipolartransistoren. Grundlage für die Herstellung bildet ein Substrat 1 (Fig. 2), das vorzugsweise ein möglichst hochohmiges, einkristallines p⁻-leitendes (geringe p-leitende Dotierung) Silizium umfasst. Der Bearbeitungsprozess des Substrates 1 beginnt mit der Erzeugung der Feldisolationsgebiete 2. Im vorliegenden Beispiel werden als Feldisolationsgebiete sogenannte "Shallow Trenches" eingesetzt. Im weiteren Herstellungsablauf sind ausgewählte Gebiete per Implantation dotiert worden. Auf diesen Gebieten, den sogenannten Wannengebieten, werden komplementäre (C)MOS-Transistoren nach herkömmlichen Methoden hergestellt. Im Ausführungsbeispiel ist in den Figuren 2 bis 8 ein MOS-Transistor 5 über einem Wannengebiet 3 dargestellt. Fig. 2 zeigt den MOS-Transistor 5 nach der Gate-Spacer-Ätzung. Wie später genauer beschrieben wird, können Wannengebiete auch dafür genutzt werden, die Funktion der komplementären Bipolartransistoren zu sichern. Dafür ist in diesem Beispiel das n-Wannengebiet 4 vorgesehen.

Nach Ätzung der Gate-Spacer wird der Prozessablauf mit der Abscheidung eines SiO₂/Si₃N₄-Schichtstapels 6, 7 fortgesetzt. Dieser Schichtstapel schützt die CMOS-Transistoren vor der Einwirkung verschiedener Prozessschritte während der Fabrikation der komplementären Bipolartransistoren. Alle Prozessschritte, gerechnet von der Abscheidung des Schichtstapels 6, 7 bis zu seiner Entfernung, werden im folgenden als Bipolarmodul bezeichnet.

Mit Hilfe einer Lackmaske 8 und üblichen anisotropen Trockenätzprozessen wird der Schutzschichtstapel 6, 7 über dem aktiven Gebiet 10, dem Transistorgebiet des npn-Transistors geöffnet. Anschließend wird eine n-Dotierung 15 per Implantation ins aktive Gebiet 10 eingebracht. Die Implantation der n-Dotierung 15 kann vor dem Entfernen der Lackmaske 8 erfolgen oder im Anschluss daran, wenn die Dicke des Schichtstapels 6, 7 ausreicht, die implantierten Ionen von den abgedeckten Gebieten fernzuhalten.

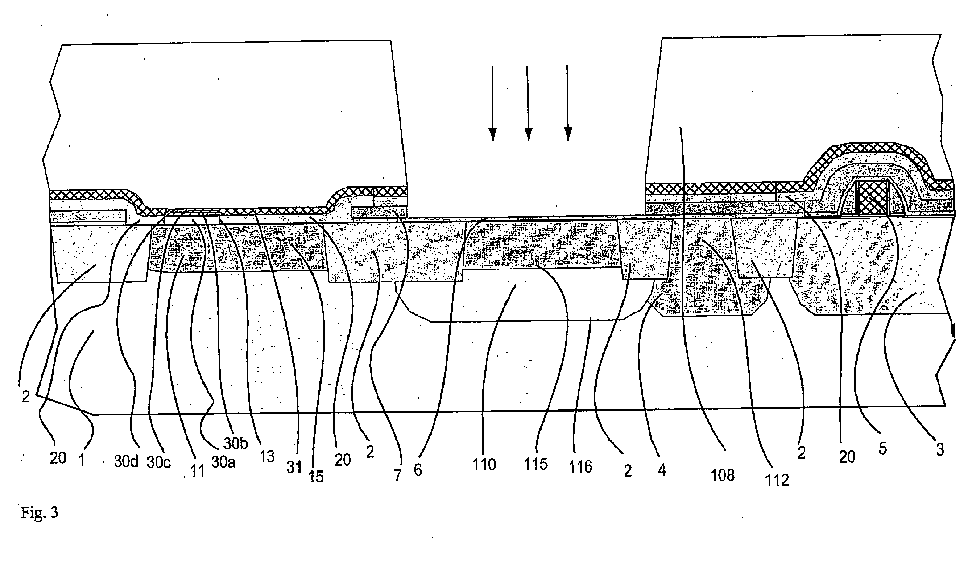

Das Ergebnis nachfolgender Prozessschritte ist in Fig. 3 dargestellt. Diese Prozessschritte werden nun beschrieben. Nach Entfernung der Lackmaske 8 (vgl. Fig. 2) wird ganzflächig eine SiO₂-Schicht 20 (Fig. 3), woraus die Isolationsgebiete 2. Art entstehen, abgeschieden. Mit Hilfe einer Lackmaske (in Fig. 3 nicht dargestellt) und bekannten Trockenätzverfahren wird ein Fenster 13 über dem Kollektorgebiet 11 des npn-Transistors geöffnet. Um Schädigungen der Si-Oberfläche beim Trockenätzen zu vermeiden, bleibt zunächst eine Restoxidschicht über der Substratoberfläche erhalten. Diese Restoxidschicht wird mit üblichen Nassätzverfahren vor dem dann folgenden Epitaxieschritt zur Herstellung der npn-Basis entfernt.

Der Epitaxieschritt beginnt mit der selektiven Abscheidung der Schicht 30a, der selektiven Pufferschicht, und wird fortgeführt mit differentiellen Abscheideschritten, bei denen die differentielle Pufferschicht 30b, die in situ mit Bor dotierte SiGe-Basisschicht 30c und die Cap-Schicht 30d, sowie auf amorphen Schichten die polykristalline Schicht 31 entstehen.

Fig. 3 zeigt einen Zustand des Prozessablaufes, in dem mit Hilfe einer Lackmaske 108 das aktive Gebiet 110, das pnp-Transistorgebiet, geöffnet wird. - Bekannte Trockenätzverfahren werden angewendet, um über dem pnp-Transistorgebiet 110 einen Schichtstapel, bestehend aus der Poly-Si-Schicht 31, der SiO₂-Schicht 20 und der Si₃N₄-Schicht 7, zu entfernen. Zum Schutz der Substratoberfläche wird der Trockenätzprozess auf der SiO₂-Schicht 6 gestoppt.

Die Lackmaske wird außerdem genutzt, um in das pnp-Transistorgebiet 110 eine p-Dotierung 115 und eine tiefere, das heißt, im Vergleich zur p-Dotierung 115 weiter zum Substratinneren hin angeordnete n-Dotierung 116 einzubringen. Die n-Dotierung 116 wird nachfolgend auch als Isolationsdotierung bezeichnet. Die gegenüber der n-Dotierung 116 flachere p-Dotierung 115 wird sowohl als Kollektor des pnp-Transistors als auch als niederohmiger Anschluss zum später entstehenden Kollektor-Kontaktgebiet genutzt.

Die Tiefe des Dotierungsprofils 115 ist so eingestellt, dass der pn-Übergang zur darunter liegenden n-Isolationsdotierung 116 nicht tiefer als die Unterkante der Feldisolationsgebiete 2 liegt. Mit Hilfe der n-Isolationsdotierung 116 wird der pnp-Transistor elektrisch vom Substrat 1 isoliert.

Gemeinsam mit der Kollektordotierung 115 wird vorzugsweise ein weiterer Implant eingebracht, der wenigstens teilweise das Kollektorgebiet amorphisiert. Dadurch kann eine defektarme Ausheilung der Implantschäden bei ausreichend niedriger Temperatur, vorzugsweise geringer als 700°C, ermöglicht werden. Der Einfluss auf bereits eingebrachte Dotierungsprofile, vor allem auf das Basis-Profil des npn-Transistors, wird dabei klein gehalten.

Die seitliche Begrenzung der Dotierung 115 durch die Feldisolationsgebiete 2 und eine vorzugsweise geringe Konzentration der n-Isolationsdotierung 116 in der Raumladungszone zum Kollektor 115 sichert geringe Kapazitätswerte zwischen dem Kollektor des pnp-Transistors und der seitlichen bzw. substratseitigen Umgebung.

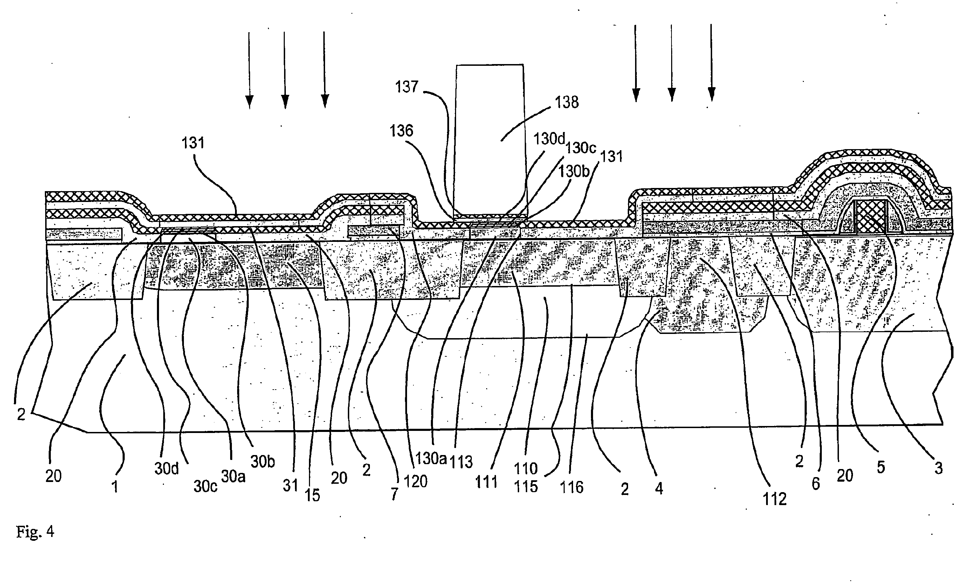

Zusätzlich ist ein geringer Anschlusswiderstand der n-Isolationsdotierung 116 anzustreben. Zu diesem Zweck wird seitlich ein n-Wannengebiet 4 mit dazugehörigem Kontaktgebiet 112 angeordnet. Eine zusätzliche Erniedrigung des Anschlusswiderstandes der n-Isolationsdotierung 116 lässt sich erreichen durch zwei-, drei- und vierseitige Umschließung der n-Isolationsdotierung 116 mit Hilfe des n-Wannengebietes 4 und entsprechenden Kontaktgebieten 112. Die nun im folgenden erläuterten Prozessschritte führen im Resultat auf ein in Fig. 4 gezeigtes Querschnittsbild. Nach Entfernung der Lackmaske 108 (Fig. 3) wird über dem pnp-Transistorgebiet 110 nasschemisch die SiO₂-Schicht 6 mit üblichen Methoden abgetragen. Anschließend wird ganzflächig an der Oberfläche eine SiO₂-Schicht 120 abgeschieden, aus der die Isolationsgebiete 3. Art gebildet werden. Mit Hilfe einer Lackmaske (in Fig. 4 nicht abgebildet) werden die Isolationsgebiete 3. Art 120 in einem Fenster 113 über dem Kollektorgebiet 111 des pnp-Transistors mit Hilfe bekannter Trockenätzprozesse geöffnet. Analog zum Prozessablauf vor dem oben beschriebenen Epitaxieschritt zur Herstellung der npn-Basis bleibt nach dem Trockenätzschritt eine Restoxidschicht (in Fig. 4 nicht dargestellt) stehen, die mit Hilfe nasschemischer Verfahren vor der Epitaxie für die Basis des pnp-Transistors entfernt wird.

Der Epitaxieschritt, bei dem die pnp-Basis erzeugt wird, besteht aus der Aufeinanderfolge von selektiver und differentieller Epitaxie. Zunächst entsteht im Fenster 113 über dem pnp-Kollektorgebiet 111 die selektive Pufferschicht 130a, anschließend die differentielle Pufferschicht 130b, dann die in situ mit Phosphor dotierte SiGe-Basisschicht 130c des pnp-Transistors und schließlich die Cap-Schicht 130d. Während der differentiellen Epitaxieschritte wächst auf dem Isoiationsgebiet 3. Art 120 die polykristalline Schicht 131.

Der Prozessablauf wird mit der Abscheidung eines Schichtstapels 136, 137, bestehend aus SiO₂ und amorphem (a-) Si, fortgesetzt. Mit Hilfe der in Fig. 4 abgebildeten Lackmaske 138 wird die a-Si-Schicht 137 auf den freibelichteten Gebieten mit üblichen Trockenätzverfahren entfernt. An dieser Stelle kann vorzugsweise n-Dotierstoff per Implantation in die vom Lack nicht maskierten Gebiete eingebracht werden. Diese Dotierung dient der Verringerung des Anschlusswiderstandes des äußeren Basisgebietes des pnp-Transistors. Sie nutzt außerdem der Erniedrigung des Emitterwiderstandes des npn-Transistors, da die polykristalline Schicht 131 auch als Anschlussgebiet für den npn-Emitter verwendet wird.

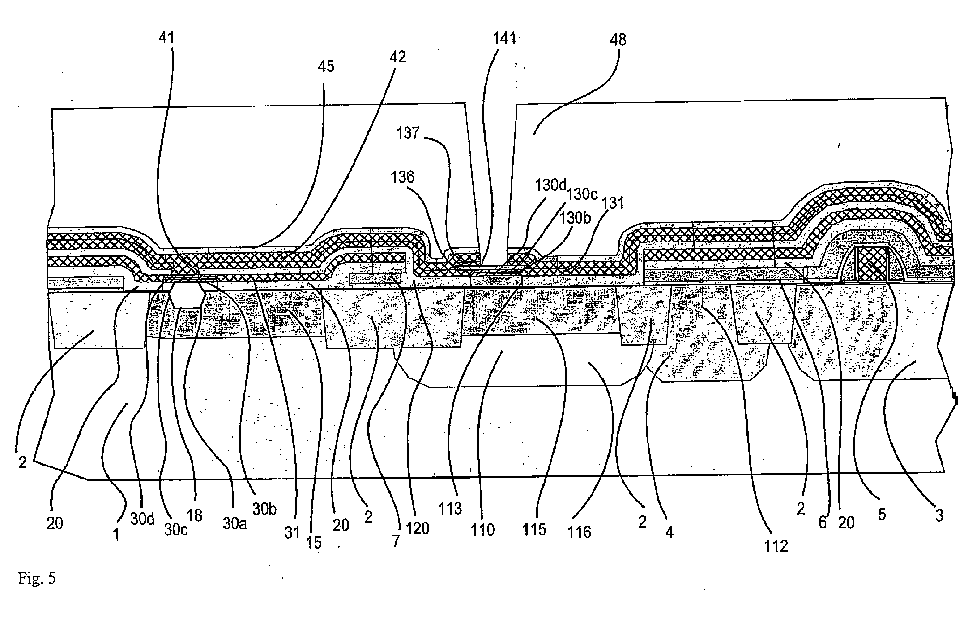

Im weiteren werden die Bearbeitungsschritte beschrieben, die von der in Fig. 4 gezeigten Momentaufnahme zu dem in Fig. 5 dargestellten Zustand führen. Nach dem Entfernen der Lackmaske 138 (Fig. 4) werden mit Hilfe einer weiteren Lackmaske (in Fig. 5 nicht dargestellt) Emitterfenster 41 (Fig. 5) über dem npn-Transistorgebiet geöffnet. Dazu wird mit einem Trockenätzschritt in den vom Lack freibelichteten Gebieten die Polysiliziumschicht 131 mit Ätzstop auf der SiO₂-Schicht 120 entfernt. Die SiO₂-Schicht 120 kann vor der Abscheidung einer n-dotierten Polysiliziumschicht, der npn-Emitterschicht 42, vollständig mittels nasschemischer Verfahren oder zunächst teilweise mit Hilfe des Trockenätzens und abschließend durch nasschemische Methoden abgetragen werden.

Eine sogenannte SIC- Dotierung 18 des npn-Kollektorgebietes mittels Implantation (SIC: selectively implanted collector) kann vor oder nach dem Entfernen der Lackmaske (in Fig. 5 nicht abgebildet) erfolgen. Entscheidend für die Wahl der Reihenfolge von Lackentfernung und Einbringen der SIC-Dotierung 18 ist die ausreichende Abschirmung der außerhalb des Emitterfensters liegenden Bereiche während der Implantation.

Nach dem Freilegen der Si-Oberfläche über der Cap-Schicht 30d im npn-Emitterfenster 41 folgt die Abscheidung der in situ n-dotierten npn-Emitterschicht 42. Die Abscheidebedingungen können nach bekannten Verfahren auch so gewählt werden, dass epitaktisches Wachstum auf einkristallinen Si-Oberflächen eintritt. Abgedeckt wird die npn-Emitterschicht 42 mit einer SiO₂-Schicht 45.

Mit Hilfe der strukturierten Lackmaske 48 (Fig. 5) entsteht nach dem Entfernen eines Schichtstapels, bestehend aus SiO₂-Schicht 45, npn-Emitterschicht 42 und Polysiliziumschicht 137, mit Hilfe von Trockenätzverfahren das pnp-Emitterfenster 141. Der Trockenätzprozess wird dabei so ausgeführt, dass die SiO₂-Schicht 136 wenigstens teilweise erhalten bleibt. Fig. 5 zeigt den bis zu diesem Prozessschritt erreichten Bearbeitungsstand.

Eine SIC-Dotierung des pnp-Kollektorgebietes mittels Implantation kann vor oder nach dem Entfernen der Lackmaske (in Fig. 5 nicht abgebildet) erfolgen.

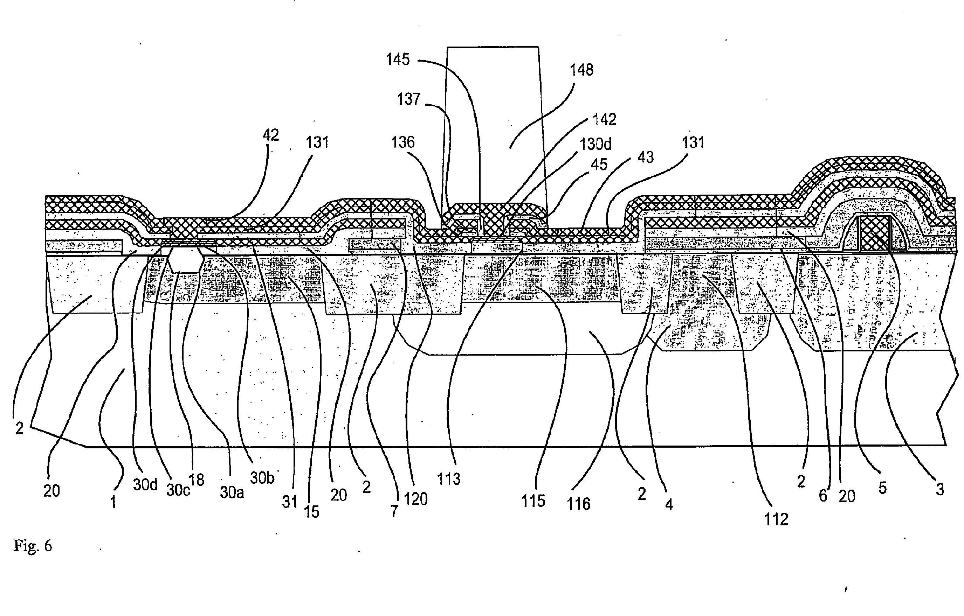

Weitere Prozessschritte werden nachfolgend unter Bezug auf Figur 6 erläutert. Im weiteren Ablauf werden nach üblichen Methoden sogenannte Inside-Spacer 145 (Fig. 6), bestehend aus SiO₂, an den Seitenwänden des pnp-Emitterfensters 141 erzeugt und eine Rest-SiO₂-Schicht, die nach dem Spacer-Ätzen über der Cap-Schicht 130d des pnp-Transistors verbleibt, nasschemisch abgetragen.

In einem nachfolgenden Epitaxieschritt wird nun die pnp-Emitterschicht 142 erzeugt. Dabei können Abscheidebedingungen für differentielle Epitaxie aber auch für selektive oder für beide Varianten zum Einsatz kommen. Vorzugsweise wird eine in situ Dotierung mit Bor angestrebt.

Fig. 6 zeigt weiterhin eine Lackmaske 148, mit deren Hilfe in Trockenätzschritten im weiteren Prozessablauf die pnp-Emitterschicht 142 sowie die SiO₂-Schicht 45 in den vom Lack befreiten Gebieten entfernt wird.

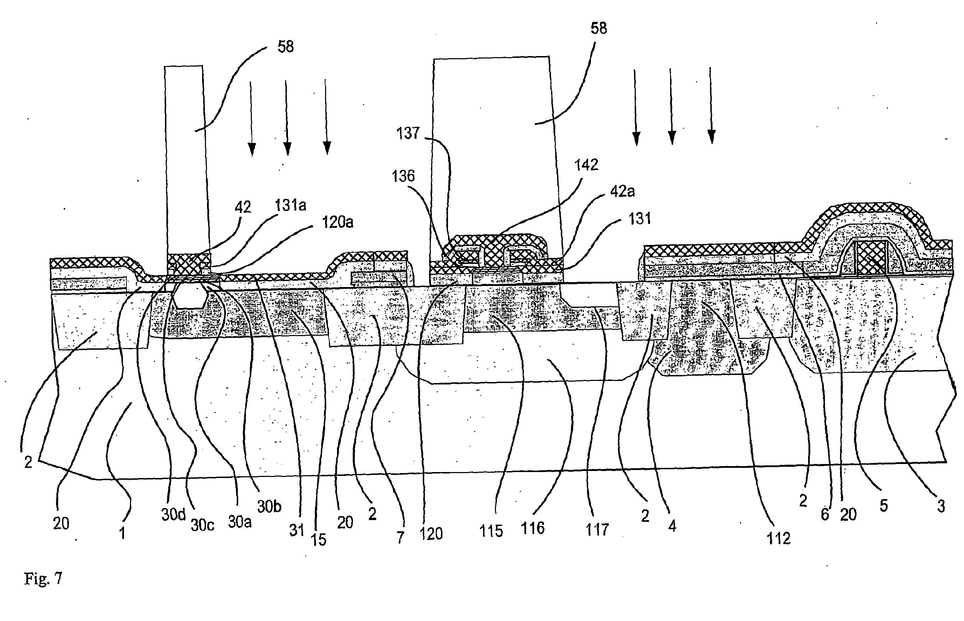

Weitere Prozessschritte werden nachfolgend unter Bezug auf Figur 7 erläutert. Eine weitere Lackmaske 58 wird angewendet, um, wie in Fig. 7 dargestellt, die Gebiete für den npn-Emitterkontakt sowie das pnp-Basiskontaktgebiet zu strukturieren. Fig. 7 zeigt einen Zustand, in dem der Schichtstapel, bestehend aus der npn-Emitterschicht 42 und der Polysiliziumschicht 131, in den nicht mit Lack bedeckten Gebieten bereits mit Hilfe eines Trockenätzschrittes entfernt ist. Bei diesem Ätzschritt kommen solche bekannten Verfahren zum Einsatz, die Silizium mit hoher Selektivität zum darunter liegenden SiO₂ abtragen.

Unter Anwendung eines zweiten Trockenätzschrittes wird die SiO₂-Schicht 120 teilweise oder vollständig abgetragen. Vor dem Entfernen der Lackmaske 58 wird ein Implantationsschritt vom p-Typ ausgeführt, womit eine möglichst hohe p-Leitfähigkeit folgender Bereiche erreicht werden soll: a) der Polysiliziumschicht 31, aus der bei einer späteren Strukturierung das npn-Basiskontaktgebiet hervorgeht, sowie b) des pnp-Kollektorkontaktgebietes 117.

Der letzte Maskenschritt innerhalb des Bipolarmoduls dient der Strukturierung der npn-Basiskontaktgebiete 31, die im Ergebnis einer Trockenätzung der Polysiliziumschicht 31 entstehen.

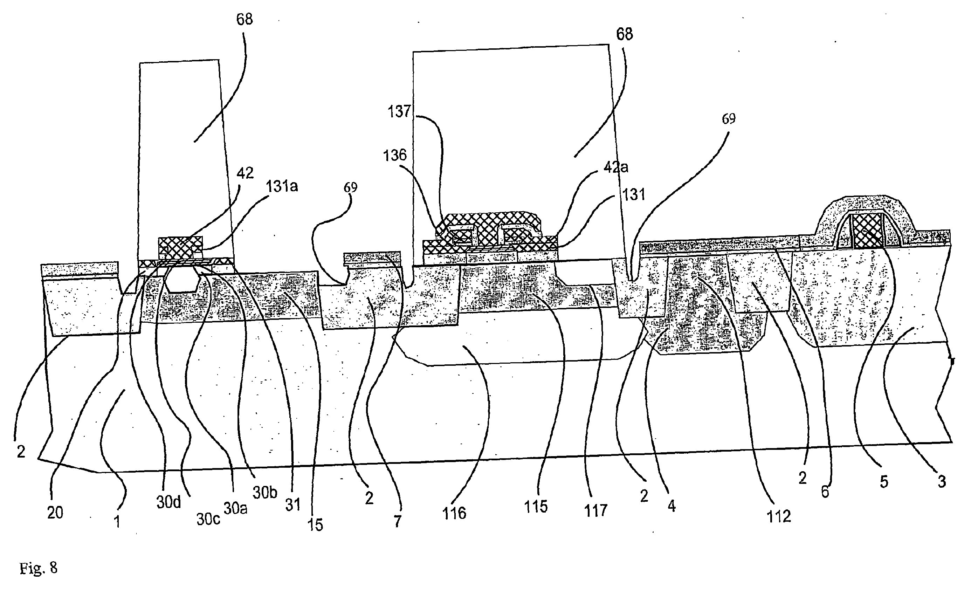

Nach einem weiteren Trockenätzschritt, bei dem die unter der Polysiliziumschicht 31 liegende SiO₂-Schicht 20 abgetragen wird, entsteht der in Fig. 8 gezeigte Zustand. Für diesen Ätzschritt wurde ein Verfahren gewählt, welches SiO₂ selektiv sowohl zu Si als auch zu Si₃N₄ ätzt, wodurch eine ausreichende Überätzzeit zur Vermeidung von ungewollten Spacern gewährleistet werden kann. Eine Überätzzeit führt zu den grabenähnlichen Vertiefungen 69 in den aus SiO₂ bestehenden Feldisolationsgebieten 2. Während der zuvor beschriebenen Ätzschritte wird das pnp-Transistorgebiet durch die Lackmaske 68 geschützt.

Der Bipolarmodul endet mit der Entfernung der Lackmaske 68 und des Schichtstapels 7, 6.

Der weitere Prozessablauf umfasst bekannte Verfahren einer CMOS- oder BiCMOS-Technologie. Dazu zählt die Implantation von Source-/DrainGebieten für die MOS-Transistoren per Lackmaske.

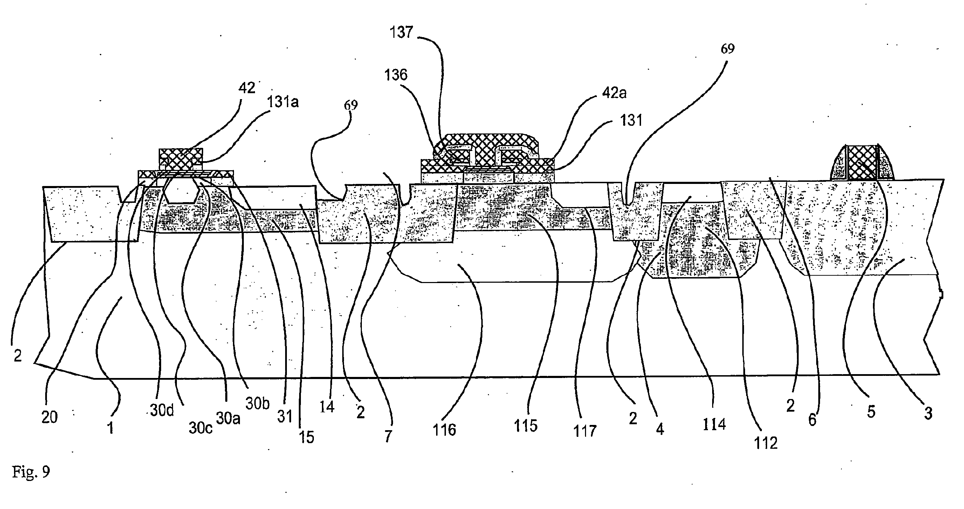

In dem hier beschriebenen Ausführungsbeispiel werden die n-Source-/Drain-Gebiete auch als Kollektoranschlussdotierung 14 des npn-Transistors genutzt (Fig. 9). Außerdem wird dabei die Dotierung 114 ins Kontaktgebiet 112 eingebracht, um einen niederohmigen Anschluss zur n-Isolationsdotierung 116 zu erreichen. Ebenso ist es möglich, aber hier nicht ausgeführt, mit Hilfe der p-Dotierung der Source-/Drain-Gebiete die pnp-Kollektordotierung im Kontaktgebiet zu verstärken.

Es kann auch vorteilhaft sein, sogenannte Extension-Gebiete für die MOS-Transistoren einzusetzen. Die Implantation dieser Gebiete per Lackmaske kann erfolgen, wenn man zuvor die vorzugsweise aus Si₃N₄ bestehenden Spacer der MOS-Transistoren nasschemisch und in selektiver Weise entfernt. In diesem Fall sind vor einem üblichen Silizierungsschritt neue Spacer an den MOS-Gates zu erzeugen. Die dafür erforderliche Schicht kann gleichzeitig als Silizid-Blocker auf ausgewählten Gebieten genutzt werden. Hierfür ist die Strukturierung einer speziellen Maske notwendig.

Der Prozessablauf wird durch typische Prozessmodule zur Verdrahtung der Transistoren komplettiert. Dazu zählen bekannte Verfahren der Abscheidung und Strukturierung von Metallschichten sowie Methoden zur Abscheidung und Planarisierung von isolierenden Zwischenschichten.

### Beispiel 3:

Der in Beispiel 2 erläuterte Prozessablauf wird in der Weise geändert, dass vor der Abscheidung des Schichtstapels 6, 7 keine Gate-Spacer an den MOS-Gates erzeugt werden. Die Fertigung von Gate-Spacern kann zum einen mit der Entfernung der Schicht 7 am Ende des Bipolarmodules erfolgen. Dabei ist im Unterschied zum Beispiel 2 kein Nassätzverfahren sondern ein Trockenätzschritt erforderlich. Zum anderen kann, wie in Beispiel 2 beschrieben, eine Schicht nach dem Bipolarmodul abgeschieden werden, die mit Hilfe eines Trockenätzschrittes für die Gate-Spacer Herstellung genutzt wird. Wie in Beispiel 2 angegeben, können definierte Gebiete vor dieser Ätzung geschützt werden, wenn zuvor eine Lackmaske strukturiert wird.

### Beispiel 4:

Der in Beispiel 2 beschriebene Bipolarmodul kann außerdem in eine SOI-MOS-Technologie integriert werden, ohne dass Auswirkungen auf die erfindungsgemäße Halbleitervorrichtung eintreten.

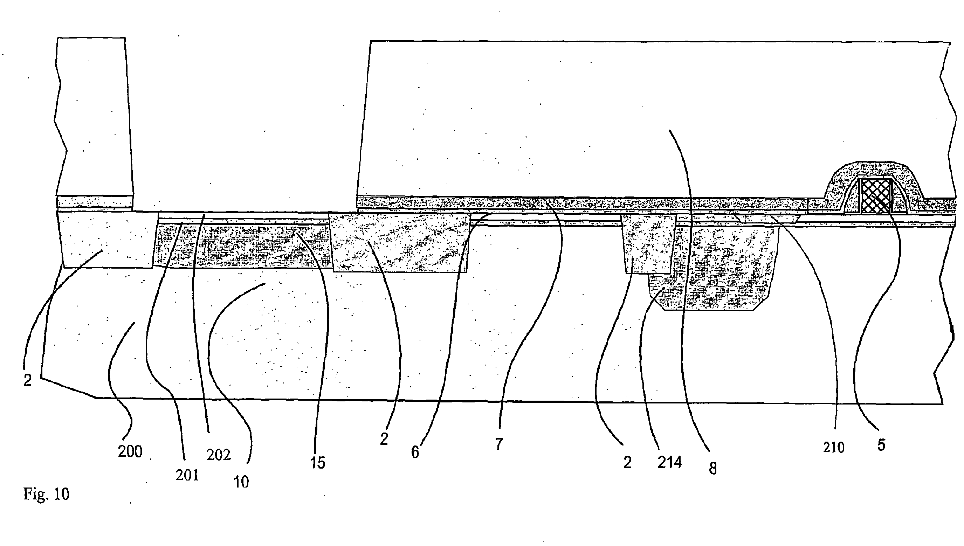

Die Ausgangssituation vor dem Bipolarmodul ist in Fig. 10 dargestellt. Im Unterschied zum Beispiel 2, Fig. 2 besteht die Substratscheibe aus Bulk-Silizium 200, einer SiO₂-Schicht 201 und einer Si-Schicht 202.

Außerdem benötigen die SOI-MOS-Transistoren keine im Bulk-Silizium 200 liegenden Wannengebiete. Typischerweise reichen die Feldisolationsgebiete 210 der SOI-MOS-Technologie, im weiteren als SOI-Feldisolationsgebiete bezeichnet, in Richtung Bulk-Silizium betrachtet nur bis zur SiO₂-Schicht 201. Neben den SOI-Feldisolationsgebieten 210 sind Feldisolationsgebiete 2, die aus flachen oder tiefen Gräben bestehen können, erzeugt worden. Diese Feldisolationsgebiete dienen wie oben beschrieben der lateralen Isolation der Kollektorgebiete.

Das Wannengebiet 214 kann mit einer speziellen Maske vor dem Bipolarmodul erzeugt werden. Das Ergebnis ist in Fig. 10 dargestellt. Es ist aber auch möglich, diesen Schritt im Anschluss an den Bipolarmodul auszuführen.

Im weiteren Prozessverlauf wird die Si-Schicht 202 mit Hilfe von Trockenätzverfahren über dem npn-Transistorgebiet 10 entfernt. Dieser Schritt kann vor oder nach dem Entfernen der Lackmaske 8 (Fig. 10) erfolgen.

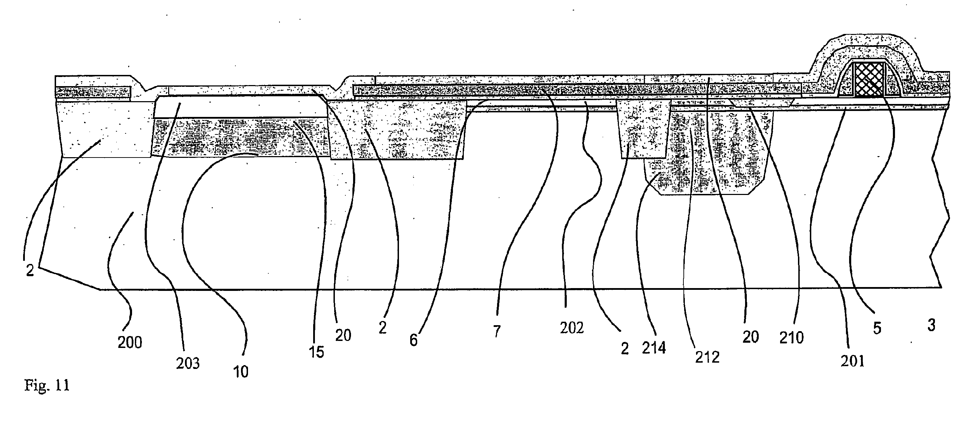

Die SiO₂-Schicht 201 wird nasschemisch abgetragen. Anschließend kann mit Hilfe eines selektiven Epitaxieschrittes vorzugsweise die Oberfläche des Siliziums im npn-Transistorgebiet 10 bis etwa auf die Höhe der Oberkante der Feldisolationsgebiete 2 angehoben werden, wobei die Si-Schicht 203 (Fig. 11) entsteht. Es ist aber auch möglich, die Oberfläche des Bulk-Siliziums 200 als Oberfläche des späteren npn-Kollektorgebietes zu verwenden.

Die Position im Prozessablauf und die Implantationsbedingungen für das Einbringen der Dotierung 15 sind so anzupassen, dass am Ende des Herstellungsprozesses ähnliche Profilverläufe wie im Beispiel 2 entstehen. Dabei ist es möglich auch Mehrfachimplantationen einzusetzen, z. B. vor oder nach dem Entfernen der Lackmaske, nach dem Abätzen der Si-Schicht 202 oder der SiO₂-Schicht 201, oder nach dem Aufwachsen der Si-Schicht 203.Der weitere Prozessablauf folgt dem Beispiel 2 mit der Abscheidung der SiO₂-Schicht 20 (Fig. 11). Eine analoge Verfahrensweise wie beim Freilegen und Verfüllen des npn-Transistorgebietes ist beim pnp-Transistor anzuwenden.

Nach Fertigstellung des Bipolarmoduls und vor der Implantation der n-Source/ Drain-Gebiete ist abweichend von Beispiel 2 zusätzlich das Kontaktgebiet 212 unter der vergrabenen SiO₂-Schicht 201 freizulegen (Fig. 11). Dafür kann eine spezielle Maske eingesetzt werden, mit deren Hilfe das Kontaktgebiet 212 zum Anschluss der n-Isolationsdotierung 116 freigelegt wird. Dabei kann eine Kombination aus Trocken- und Nassätzen eingesetzt werden. Außerdem kann bei diesem Maskenschritt auch das Wannengebiet 214 eingebracht werden.

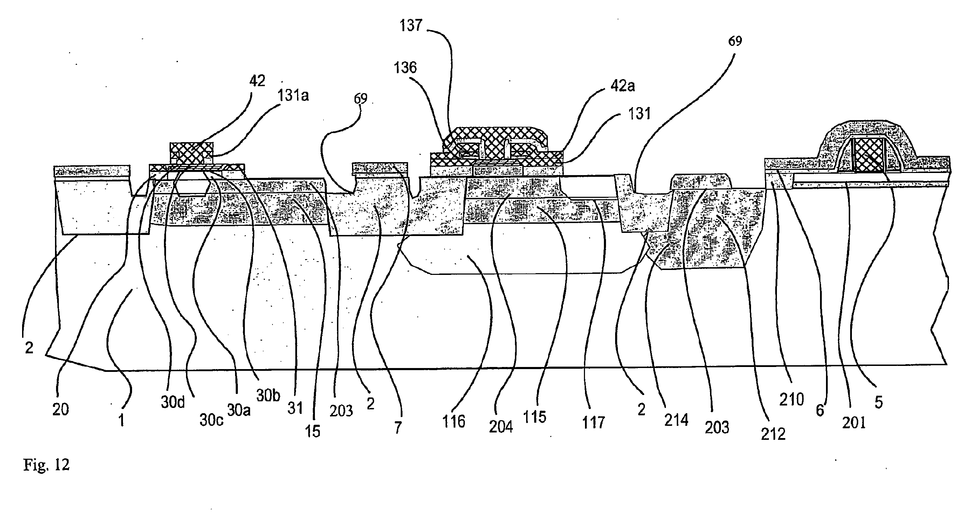

Es ist jedoch auch möglich, ohne weitere Maske das Kontaktgebiet 212 freizulegen. Diese Variante ist in Fig. 12 verwirklicht. In diesem Fall ist per Layout ein Kollektorkontaktgebiet des zweiten Transistortyps in diesem Gebiet zu definieren. Das Wannengebiet 214 ist in diesem Fall wie oben beschrieben mit Hilfe einer speziellen Maske zu erzeugen.

## Patentansprüche

1. Komplementäre Bipolar-Halbleitervorrichtung, nachfolgend CBi-Halbleitervorrichtung genannt,
- mit einem Substrat (1) eines ersten Leitfähigkeitstyps und einer Anzahl darauf vorgesehener aktiver Bipolartransisistorgebiete (A, B), die in lateraler Richtung von flachen Feldisolationsgebieten (2) begrenzt werden,
- bei der in einer ersten Teilanzahl der aktiven Bipolartransistorgebiete vertikale npn- Bipolartransistoren, und in einer zweiten Teilanzahl der aktiven Bipolartransistorgebiete vertikale pnp-Bipolartransistoren angeordnet sind,
- wobei entweder ein Transistortyp oder beide Transistortypen in ein und demselben jeweiligen aktiven Bipolartransistorgebiet sowohl ein Kollektorgebiet (11, 111) als auch ein Kollektorkontaktgebiet (14, 114) aufweisen,
bei einem ersten der beiden vertikalen Transistortypen, bei dem der Leitfähigkeitstyp des Substrates (1) mit dem des Kollektorgebiets (11, 111) übereinstimmt, ein Isolationsdotierungsgebiet (116) zwischen Kollektorgebiet (11, 111) und Substrat (1) vorgesehen ist, das ausgebildet ist, eine elektrische Isolation von Kollektor und Substrat zu bewirken,
wobei das Kollektorgebiet (11, 111) entweder des ersten Transistortyps oder beider Transistortypen lateral durch die flachen Feldisolationsgebiete (2) begrenzt ist,
**dadurch gekennzeichnet, dass**
die vertikalen npn- und pnp-Transistoren eine epitaxiale Basis (30, 130) aufweisen und dass
beim ersten Transistortyp im Bereich einer Grenzfläche zwischen dem Kollektorgebiet (11, 111) und dem Isolationsdotierungsgebiet (116) ein p-n-Übergang ausgebildet ist, der im gesamten jeweiligen aktiven Bipolartransistorgebiet nicht tiefer angeordnet ist als die Unterkante der flachen Feldisolationsgebiete (2).

2. CBi-Halbleitervorrichtung nach einem der vorstehenden Ansprüche, bei der Dotierstoffkonzentration der Isolationsdotierung (116) im Raumladungsgebiet nahe dem Kollektor kleiner als 1 x 10¹⁷ cm⁻³ ist.

3. CBi-Halbleitervorrichtung nach einem der vorstehenden Ansprüche, bei der die Dotierstoffkonzentration der Isolationsdotierung (116) im Raumladungsgebiet nahe dem Kollektor maximal 1 x 10¹⁶ cm⁻³ beträgt.

4. CBi-Halbleitervorrichtung nach einem der vorstehenden Ansprüche, bei der die Dotierstoffkonzentration der Isolationsdotierung (116) im Raumladungsgebiet nahe dem Kollektor kleiner als 1 x 10¹⁵ cm⁻³ ist.

5. CBi-Halbleitervorrichtung nach einem der vorstehenden Ansprüche, bei der im ersten Transistortyp in einem lateral benachbarten aktiven Gebiet eine Wanne (4) des dem ersten Leitfähigkeitstyp entgegengesetzten, zweiten Leitfähigkeitstyps und ein ihr zugeordnetes Kontaktgebiet (112) des zweiten Leitfähigkeitstyps vorgesehen sind.

6. CBi-Halbleitervorrichtung nach einem der vorstehenden Ansprüche, bei der die Dotierstoffdosis der Wanne (4) zwischen 5 x 10¹² cm ⁻² und 5 x 10¹⁴ cm ⁻² beträgt.

7. CBi-Halbleitervorrichtung nach einem der vorstehenden Ansprüche, bei der die Dotierstoffdosis der Wanne (4) eingeschränkt zwischen 1 x 10¹³ cm⁻² und 2 x 10¹⁴ cm ⁻² beträgt.

8. CBi-Halbleitervorrichtung nach einem der Ansprüche 5 bis 7, bei der die Wanne (4) eine in einem MOS-Prozess hergestellte Wannne des zweiten Leitfähigkeitstyps ist.

9. CBi-Halbleitervorrichtung nach einem der vorstehenden Ansprüche, bei der die Dotierstoffkonzentration des Kontaktgebiets (112) zwischen 1 x 10¹⁷ cm⁻³ und 1 x 10²¹ cm⁻³ beträgt.

10. CBi-Halbleitervorrichtung nach einem der vorstehenden Ansprüche, bei der die Wanne (4) und das Substratkontaktgebiet das Isolationsdotierungsgebiet (116) lateral an zwei, alternativ drei, alternativ vier Seiten umgeben.

11. CBi-Halbleitervorrichtung nach einem der vorstehenden Ansprüche, bei der die maximale Dotierstoffkonzentration im Kollektorkontaktgebiet (14, 114) des ersten oder zweiten Transistortyps zwischen 1 x 10¹⁸ cm⁻³ und 5 x 10²⁰ cm⁻³ beträgt.

12. CBi-Halbleitervorrichtung nach einem der vorstehenden Ansprüche, bei der der erste oder der zweite Transistortyp oder beide Transistortypen ein inneres Basisgebiet aufweisen, unterhalb dessen mit entweder gleicher oder annähernd gleicher lateraler Erstreckung wie das innere Basisgebiet ein zweites Kollektorgebiet angeordnet ist, welches bei gleichem Leitfähigkeitstyp höher dotiert ist als zumindest ein an das zweite Kollektorgebiet angrenzender Bereich des Kollektorgebietes.

13. CBi-Halbleitervorrichtung nach einem der vorstehenden Ansprüche, bei der die epitaxiale Basis (30, 130) einen Basisschichtstapel mit einer Mehrzahl Schichten umfasst, die im inneren Basisgebiet einkristallin und in Abschnitten, die in lateraler Richtung außerhalb des inneren Basisgebiets liegen und nachfolgend als Basiskontaktgebiet bezeichnet werden, polykristallin ausgebildet sind.

14. CBi-Halbleitervorrichtung nach einem der vorstehenden Ansprüche, bei der der Basisschichtstapel eine entweder aus Silizium oder aus Silizium-Germanium gefertigte Basisschicht enthält, die eine Dicke von zwischen 1 und 100 nm, insbesondere von zwischen 1 und 35 nm aufweist.

15. CBi-Halbleitervorrichtung nach einem der vorstehenden Ansprüche, bei der der Basisschichtstapel eine emitterseitig an die Basisschicht angrenzende Deckelschicht enthält.

16. CBi-Halbleitervorrichtung nach einem der vorstehenden Ansprüche, bei der eine oder mehrere der Schichten des Basisschichtstapels mit Kohlenstoff dotiert sind.

17. CBi-Halbleitervorrichtung nach einem der vorstehenden Ansprüche, bei der ein Emitter (40, 140) entweder des ersten oder des zweiten oder beider Transistortypen T-förmig ausgebildet ist.

18. CBi-Halbleitervorrichtung nach einem der vorstehenden Ansprüche, bei der ein im Basisschichtstapel des ersten Transistortyps vorgesehener substratseitiger Abschnitt des Basiskontaktgebiets aus demselben, gleichzeitig abgeschiedenen polykristallinen Halbleitermaterial gefertigt ist wie ein basisseitiger, äußerer Abschnitt des T-Querbalkens des Emitters im zweiten Transistortyp.

19. CBi-Halbleitervorrichtung nach einem der vorstehenden Ansprüche, bei der ein im Basisschichtstapel des ersten Transistortyps vorgesehener emitterseitiger vertikaler Schichtabschnitt des Basiskontaktgebiets aus demselben, gleichzeitig abgeschiedenen polykristallinen Halbleitermaterial gefertigt ist wie ein kontaktseitiger vertikaler Schichtabschnitt des T-Querbalkens des Emitters im zweiten Transistortyp.

20. CBi-Halbleitervorrichtung nach einem der vorstehenden Ansprüche, bei der
- im ersten Transistortyp das polykristalline Basiskontaktgebiet im Basisschichtstapel eine parallel zur Substratoberfläche verlaufende Grenzfläche aufweist, entlang welcher Korngrenzen hier aneinander grenzender, basisseitiger und emitterseitiger, polykristalliner vertikaler Schichtabschnitte ausgerichtet sind, und bei der
- im zweiten Transistortyp der Emitter eine parallel zur Substratoberfläche verlaufende Grenzfläche aufweist, entlang welcher Korngrenzen hier aneinander grenzender, basisseitiger und kontaktseitiger, polykristalliner vertikaler Schichtabschnitten ausgerichtet sind.

21. CBi-Halbleitervorrichtung nach einem der vorstehenden Ansprüche, bei der die flachen Feldisolationsgebiete die Form flacher Gräben haben.

22. CBiMOS- oder CBiCMOS-Halbleitervorrichtung nach einem der vorstehenden Ansprüche, mit zusätzlich mindestens einem MOS-Halbleiterbauelement oder mit komplementären MOS-Halbleiterbauelementen.

23. CBi- oder CBiMOS- oder CBiCMOS-Halbleitervorrichtung nach einem der vorstehenden Ansprüche, bei der das Substrat p-leitend und der erste Transistortyp ein pnp-Transistor und der zweite Transistortyp ein npn-Transistor ist.

24. Verfahren zur Herstellung komplementärer, hochfrequenztauglicher Bipolartransistoren in einer Halbleitervorrichtung nach einem der Ansprüche 1 bis 23,
- bei dem die Schichten beider Bipolartransistortypen auf aktiven Bipolartransistorgebieten eines durch flache Feldisolationsgebiete (2) vorstrukturierten Substrates eines ersten Leitfähigkeitstyps abgeschieden und strukturiert werden,
- bei dem bei einem oder beiden Bipolartransistortypen ein Kollektorgebiet (11, 111) und ein Kollektorkontaktgebiet (14, 114) innerhalb ein und desselben aktiven Bipolartransistorgebiets ausgebildet werden ,
- bei dem bei demjenigen Bipolartransistortyp, dessen Kollektorgebiet denselben Leitfähigkeitstyp aufweist wie das Substrat, in einem Implantationsschritt ein Isolationsdotierungsgebiet (116) unterhalb des Kollektorgebiets erzeugt wird, derart, dass das Kollektorgebiet vom Substrat elektrisch isoliert ist
**dadurch gekennzeichnet, dass**
der Implantationsschritt derart durchgeführt wird, dass im Bereich einer Grenzfläche zwischen dem Kollektorgebiet (11, 111) und dem Isolationsdotierungsgebiet (116) ein p-n-Übergang ausgebildet ist, der im gesamten jeweiligen aktiven Bipolartransistorgebiet nicht tiefer angeordnet ist als die Unterkante der flachen Feldisolationsgebiete (2).

25. Verfahren nach Anspruch 24, bei dem während des Implantationsschrittes zur Erzeugung des Kollektorgebietes ein zweiter Implantationsschritt zur zumindest teilweisen Amorphisierung des Kollektorgebietes durchgeführt wird.

26. Verfahren nach Anspruch 25, bei dem nach dem zweiten Implantationsschritt ein Schritt der Rekristallisation des Kollektorgebietes durchgeführt wird.

27. Verfahren nach einem der Ansprüche 24 bis 26, bei dem ein im Basisschichtstapel des ersten Transistortyps vorgesehener substratseitiger Schichtabschnitt des Basiskontaktgebiets gleichzeitig abgeschieden wird wie ein basisseitiger Schichtabschnitt des T-Querbalkens des Emitters im zweiten Transistortyp.

28. Verfahren nach einem der Ansprüche 24 bis 27, bei dem ein im Basisschichtstapel des ersten Transistortyps vorgesehener emitterseitiger Schichtabschnitt des Basiskontaktgebiets gleichzeitig abgeschieden wird wie ein kontaktseitiger Schichtabschnitt des T-Querbalkens des Emitters im zweiten Transistortyp.

29. Verfahren nach einem der Ansprüche 24 bis 28, bei dem das Bipolar-Verfahrensmodul im Rahmen des CMOS-Prozesses im Anschluss an eine Gatestrukturierung und eine Bildung von Gate-Abstandshaltern und vor der Implantation von Source- und Draingebieten durchgeführt wird.

30. Verfahren nach einem der Ansprüche 24 bis 29, bei dem die Bipolartransistoren auf einem SOI-Substrat hergestellt werden.

31. Verfahren nach Anspruch 30, bei dem die Bipolartransistoren auf einem SOI-Substrat mit einer dünnen Si-Deckschicht von weniger als 50nm Schichtdicke hergestellt werden.

32. Verfahren zur Herstellung eines CBiMOS- oder CBiCMOS-Halbleitervorrichtung, **gekennzeichnet durch** ein in den das Verfahren integriertes Verfahrensmodul mit den Schritten des Verfahrens nach einem der Ansprüche 24 bis 31.

## Claims

1. Complementary bipolar semiconductor device, hereinafter referred to as a CBi-semiconductor device,
- having a substrate (1) of a first conductivity type and a number of active bipolar transistor regions (A, B) provided thereon, which are bounded in the lateral direction by flat field insulation regions (2),
- wherein vertical npn bipolar transistors are arranged in a first partial number of the active bipolar transistor regions, and vertical pnp bipolar transistors are arranged in a second partial number of the active bipolar transistor regions,
- wherein either one type of transistor or both types of transistor comprise both a collector region (11, 111) and a collector contact region (14, 114) in one and the same active bipolar transistor region,
in a first of the two vertical types of transistor in which the conductivity type of the substrate (1) coincides with that of the collector region (11, 111), an insulation doping region (116) is provided between the collector region (11, 111) and the substrate (1), which is designed to achieve electrical insulation of the collector and substrate,
wherein the collector region (11, 111) of either the first type of transistor or of both types of transistor is laterally bounded by the flat field insulation regions (2),
**characterised in that**
the vertical npn and pnp transistors have an epitaxial base (30, 130) and **in that**
in the first type of transistor, in the region of an interface between the collector region (11, 111) and the insulation doping region (116), a p-n junction is formed which is arranged in the entire active bipolar transistor region no lower down than the lower edge of the flat field insulation regions (2).

2. CBi-semiconductor device according to one of the preceding claims, wherein the dopant concentration of the insulation doping (116) in the space charge region close to the collector is less than 1 x 10¹⁷ cm⁻³.

3. CBi-semiconductor device according to one of the preceding claims, wherein the dopant concentration of the insulation doping (116) in the space charge region close to the collector is not more than 1 x 10¹⁶ cm⁻³.

4. CBi-semiconductor device according to one of the preceding claims, wherein the dopant concentration of the insulation doping (116) in the space charge region close to the collector is less than 1 x 10¹⁵ cm⁻³.

5. CBi-semiconductor device according to one of the preceding claims, wherein in the first type of transistor, in a laterally adjacent active region, are provided a well (4) of the second conductivity type the opposite of the first conductivity type and a contact region (112) of the second conductivity type associated therewith.

6. CBi-semiconductor device according to one of the preceding claims, wherein the dose of dopant in the well (4) is between 5 x 10¹² cm⁻² and 5 x 10¹⁴ cm⁻².

7. CBi-semiconductor device according to one of the preceding claims, wherein the dose of dopant in the well (4) is restricted to between 1 x 10¹³ cm⁻² and 2 x 10¹⁴ cm⁻².

8. CBi-semiconductor device according to one of claims 5 to 7, wherein the well (4) is a well of the second conductivity type, produced in an MOS process.

9. CBi-semiconductor device according to one of the preceding claims, wherein the dopant concentration of the contact region (112) is between 1 x 10¹⁷ cm⁻³ and 1 x 10²¹ cm⁻³.

10. CBi-semiconductor device according to one of the preceding claims, wherein the well (4) and the substrate contact region surround the insulation doping region (116) laterally on two, or alternatively three, or alternatively four sides.

11. CBi-semiconductor device according to one of the preceding claims, wherein the maximum dopant concentration in the collector contact region (14, 114) of the first or second type of transistor is between 1 x 10¹⁸ cm⁻³ and 5 x 10²⁰ cm⁻³.

12. CBi-semiconductor device according to one of the preceding claims, wherein the first or second type of transistor or both types of transistor have an inner base region below which a second collector region is arranged, of either the same or substantially the same lateral extent as the inner base region, said second collector region being more highly doped, with the same conductivity type, than at least one area of the collector region adjoining the second collector region.

13. CBi-semiconductor device according to one of the preceding claims, wherein the epitaxial base (30, 130) comprises a base layer stack having a number of layers, which are of monocrystalline construction in the inner base region and of polycrystalline construction in sections located laterally outside the inner base region and hereinafter referred to as the base contact region.

14. CBi-semiconductor device according to one of the preceding claims, wherein the base layer stack contains a base layer made of either silicon or silicon/germanium, with a thickness of between 1 and 100 nm, more particularly between 1 and 35 nm.

15. CBi-semiconductor device according to one of the preceding claims, wherein the base layer stack contains a covering layer adjoining the base layer on the emitter side.

16. CBi-semiconductor device according to one of the preceding claims, wherein one or more of the layers in the base layer stack are doped with carbon.

17. CBi-semiconductor device according to one of the preceding claims, wherein an emitter (40, 140) of either the first or second or both types of transistor is of T-shaped construction.

18. CBi-semiconductor device according to one of the preceding claims, wherein a section of the base contact region provided on the substrate side of the base layer stack of the first type of transistor is made of the same polycrystalline, simultaneously deposited semiconductor material as a base-side outer section of the crossbar of the T of the emitter in the second type of transistor.

19. CBi-semiconductor device according to one of the preceding claims, wherein a vertical layer section of the base contact region provided on the emitter side of the base layer stack of the first type of transistor is made of the same, simultaneously deposited polycrystalline semiconductor material as a contact-side vertical layer section of the crossbar of the T of the emitter in the second type of transistor.

20. CBi-semiconductor device according to one of the preceding claims, wherein
- in the first type of transistor the polycrystalline base contact region in the base layer stack has an interface extending parallel to the substrate surface, along which grain boundaries of base-side and emitter-side polycrystalline vertical layer sections adjoining here are aligned, and wherein
- in the second type of transistor the emitter has an interface extending parallel to the substrate surface, along which grain boundaries of base-side and contact-side polycrystalline vertical layer sections adjoining here are aligned.

21. CBi-semiconductor device according to one of the preceding claims, wherein the flat field insulation regions are in the form of flat channels.

22. CBiMOS or CBiCMOS semiconductor device according to one of the preceding claims, additionally having at least one MOS semiconductor component or complementary MOS semiconductor components.

23. CBi or CBiMOS or CBiCMOS semiconductor device according to one of the preceding claims, wherein the substrate is p-conductive and the first type of transistor is a pnp transistor and the second type of transistor is an npn transistor.

24. Process for producing complementary, high frequency-compatible bipolar transistors in a semiconductor device according to one of claims 1 to 23,
- wherein the layers of the two types of bipolar transistor are deposited and structured on active bipolar transistor regions of a substrate of a first conductivity type that is prestructured by flat field insulation regions (2),
- wherein in one or both types of bipolar transistor a collector region (11, 111) and a collector contact region (14, 114) are formed within one and the same active bipolar transistor region,
- wherein in the type of bipolar transistor in which the collector region has the same type of conductivity as the substrate, an insulation doping region (116) is formed below the collector region in an implantation step, such that the collector region is electrically insulated from the substrate,
**characterised in that**
the implantation step is carried out such that in the region of an interface between the collector region (11, 111) and the insulation doping region (116), a p-n junction is formed which is arranged no lower down in the entire active bipolar transistor region than the lower edge of the flat field insulation regions (2).

25. Process according to claim 24, wherein during the implantation step for producing the collector region a second implantation step is carried out for rendering the collector region at least partially amorphous.

26. Process according to claim 25, wherein after the second implantation step a step of recrystallising the collector region is carried out.

27. Process according to one of claims 24 to 26, wherein a substrate-side layer section of the base contact region provided in the base layer stack of the first type of transistor is deposited at the same time as a base-side layer section of the crossbar of the T of the emitter in the second type of transistor.

28. Process according to one of claims 24 to 27, wherein an emitter-side layer section of the base contact region provided in the base layer stack of the first type of transistor is deposited at the same time as a contact-side layer section of the crossbar of the T of the emitter in the second type of transistor.

29. Process according to one of claims 24 to 28, wherein the bipolar process module is carried out within the scope of the CMOS process following a gate structuring and the formation of gate spacers and before the implantation of source and drain regions.

30. Process according to one of claims 24 to 29, wherein the bipolar transistors are produced on an SOI substrate.

31. Process according to claim 30, wherein the bipolar transistors are produced on an SOI substrate with a thin covering layer of Si less than 50 nm thick.

32. Process for producing a CBiMOS or CBiCMOS semiconductor device, **characterised by** a process module integrated into the process, having the steps of the process according to one of claims 24 to 31.

## Revendications

1. Dispositif semi-conducteur bipolaire complémentaire, appelé ci-après dispositif semi-conducteur CBi,
- avec un substrat (1) d'un premier type de conductivité et une pluralité de domaines de transistors bipolaires (A, B) actifs, prévus au-dessus de celui-ci, qui sont délimités en direction latérale par des domaines d'isolation de champ (2) plats,
- dans lequel dans une première pluralité partielle des domaines de transistors bipolaires actifs, sont disposés des transistors bipolaires NPN verticaux, et, dans une deuxième pluralité partielle des domaines de transistors bipolaires actifs, sont disposés des transistors bipolaires PNP verticaux,
- où soit un type de transistor soit les deux types de transistor présentent, dans un seul et même domaine de transistor bipolaire actif respectif, tant un domaine de collecteur (11, 111) qu'également un domaine de contact de collecteur (14, 114), dans un premier des deux types de transistor verticaux, dans lequel le type de conductivité du substrat (1) coïncide avec celui du domaine de collecteur (11, 111), un domaine de dopage d'isolation (116) est prévu entre domaine de collecteur (11, 111) et substrat (1), réalisé pour provoquer une isolation électrique de collecteur et de substrat,
- où le domaine de collecteur (11, 111), soit du premier type de transistor, soit des deux types de transistor, est limité latéralement par les domaines d'isolation de champ (2) plats,
**caractérisé en ce que**
les transistors NPN et PNP verticaux présentent une base épitaxiale (30, 130), et **en ce que**
dans le cas du premier type de transistor, dans la zone d'une surface limite entre la domaine de collecteur (11, 111) et le domaine de dopage d'isolation (116), est réalisée une transition p-n qui, dans l'ensemble du domaine de transistor bipolaire actif respectif, n'est pas disposé plus profondément que l'arête inférieure des domaines d'isolation de champ (2) plats.

2. Dispositif semi-conducteur CBi selon l'une des revendications précédentes, dans lequel la concentration en substance de dopage du dopage d'isolation (116) dans le domaine de charge d'espace près du collecteur est inférieure à 1 x 10¹⁷ cm⁻³.

3. Dispositif semi-conducteur CBi selon l'une des revendications précédentes, dans lequel la concentration en substance de dopage du dopage d'isolation (116) dans le domaine de charge d'espace près du collecteur est au maximum de 1 x 10¹⁶ cm⁻³.

4. Dispositif semi-conducteur CBi selon l'une des revendications précédentes, dans lequel la concentration en substance de dopage du dopage d'isolation (116) dans le domaine de charge d'espace près du collecteur est inférieure à 1 x 10¹⁵ cm⁻³.

5. Dispositif semi-conducteur CBi selon l'une des revendications précédentes, dans lequel, dans le premier type de transistor, dans un domaine actif latéralement voisin, sont prévus une auge (4) du deuxième type de conductivité, opposé au premier type de conductivité, et un domaine de contact (112) du deuxième type de conductivité lui étant associé.

6. Dispositif semi-conducteur CBi selon l'une des revendications précédentes, dans lequel la dose de dopage de l'auge (4) est entre 5 × 10¹² cm⁻² et 5 × 10¹⁴ cm⁻².

7. Dispositif semi-conducteur CBi selon l'une des revendications précédentes, dans lequel la dose de dopage de l'auge (4) est limitée entre 1 x 10¹³ cm⁻² et 2 x 10¹⁴ cm⁻².

8. Dispositif semi-conducteur CBi selon l'une des revendications 5 à 7, dans lequel l'auge (4) est une auge du deuxième type de conductivité, fabriquée selon un procédé MOS.

9. Dispositif semi-conducteur CBi selon l'une des revendications précédentes, dans lequel la concentration en substance de dopage du domaine de contact (112) est entre 1 x 10¹⁷ cm⁻³ et 1 x 10²¹ cm⁻³.

10. Dispositif semi-conducteur CBi selon l'une des revendications précédentes, dans lequel l'auge (4) et le domaine de contact de substrat entourent le domaine de dopage d'isolation (116) latéralement sur deux, en variante trois, en variante quatre côtés.

11. Dispositif semi-conducteur CBi selon l'une des revendications précédentes, dans lequel la concentration en substance de dopage maximale dans le domaine de contact de collecteur (14, 114) du premier ou du deuxième type de transistor est entre 1 x 10¹⁸ cm⁻³ et 5 x 10²⁰ cm⁻³.

12. Dispositif semi-conducteur CBi selon l'une des revendications précédentes, dans lequel le premier ou le deuxième type de transistor ou les deux types de transistors présentent un domaine de base intérieur, au-dessous duquel, avec une étendue latérale soit identique, soit à peu près identique au domaine de base intérieur, est disposé un deuxième domaine de collecteur, qui est dopé plus fortement, pour un type de conductivité identique, qu'au moins une zone du domaine de collecteur, limitrophe au deuxième domaine de collecteur.

13. Dispositif semi-conducteur CBi selon l'une des revendications précédentes, dans lequel la base épitaxiale (30, 130) comprend un empilement de couches de base, avec une pluralité de couches qui, dans le domaine de base intérieur, sont monocristallines et dans des tronçons, qui sont situés en direction latérale à l'extérieur du domaine de base intérieur et appelés ci-après domaine de contact de base, sont polycristallines.

14. Dispositif semi-conducteur CBi selon l'une des revendications précédentes, dans lequel l'empilement de couches de base contient une couche de base fabriquée soit en silicium soit en silicium-germanium, présentant une épaisseur entre 1 et 100 nm, en particulier entre 1 et 35 nm.

15. Dispositif semi-conducteur CBi selon l'une des revendications précédentes, dans lequel l'empilement de couches de base contient une couche de couverture limitrophe, côté émetteur, à la couche de base.

16. Dispositif semi-conducteur CBi selon l'une des revendications précédentes, dans lequel une ou plusieurs des couches de l'empilement de couches de base sont dopées avec du carbone.

17. Dispositif semi-conducteur CBi selon l'une des revendications précédentes, dans lequel un émetteur (40, 140), soit du premier, soit du deuxième type de transistor soit des deux types de transistor, est réalisé en forme de T.

18. Dispositif semi-conducteur CBi selon l'une des revendications précédentes, dans lequel un tronçon du domaine de contact de base situé côté substrat, prévu dans l'empilement de couches de base du premier type de transistor , est fabriqué à partir du même matériau semi-conducteur polycristallin, déposé simultanément, qu'un tronçon extérieur, situé côté base, de la barre transversale de T de l'émetteur dans le deuxième type de transistor.

19. Dispositif semi-conducteur CBi selon l'une des revendications précédentes, dans lequel un tronçon de couche vertical du domaine de contact de base, situé côté émetteur, prévu dans l'empilement de couches de base du premier type de transistor, est fabriqué à partir du même matériau semi-conducteur polycristallin, déposé simultanément, qu'un tronçon de couche vertical, situé côté contact, de la barre transversale de T de l'émetteur dans le deuxième type de transistor.

20. Dispositif semi-conducteur CBi selon l'une des revendications précédentes, dans lequel :
- dans le premier type de transistor, le domaine de contact de base polycristallin, dans l'empilement de couches de base, présente une surface limite s'étendant parallèlement à la surface du substrat, surface limite le long de laquelle des limites de grain de tronçons de couche verticaux polycristallins, situés côté base et côté émetteur, limitrophes ici les unes aux autres, sont orientées, et pour lequel
- dans le deuxième type de transistor, l'émetteur présente une surface limite s'étendant parallèlement à la surface du substrat, surface limite le long de laquelle des limites de grain de tronçons de couche verticaux polycristallins, situés côté base et côté contact, limitrophes ici les unes aux autres, sont orientées.

21. Dispositif semi-conducteur CBi selon l'une des revendications précédentes, dans lequel les domaines d'isolation de champ plats ont la forme de tranchées plates.

22. Dispositif semi-conducteur CBiMOS ou CBICMOS selon l'une des revendications précédentes, avec en plus au moins un composant à semi-conducteur MOS ou avec des composants à semi-conducteur MOS complémentaires.

23. Dispositif semi-conducteur CBiMOS ou CBICMOS selon l'une des revendications précédentes, dans lequel le substrat est à conductivité p et le premier type de transistor est un transistor PNP et le deuxième type de transistor est un transistor NPN.

24. Procédé de fabrication de transistors bipolaires aptes aux hautes fréquences, complémentaires, dans un dispositif semi-conducteur selon l'une des revendications 1 à 23,
- dans lequel les couches des deux types de transistors bipolaires sont déposées sur des domaines de transistor bipolaire actifs d'un substrat d'un premier type de conductivité, préstructuré au moyen de domaines d'isolation de champ (2) plats, et sont structurées,
- dans lequel, pour l'un ou les deux types de transistors bipolaires, un domaine de collecteur (11, 111) et un domaine de contact de collecteur (14, 114) sont réalisés à l'intérieur d'un seul et même domaine de transistor bipolaire actif,
- dans lequel, pour le type de transistor bipolaire dont le domaine de collecteur présente le même type de conductivité que le substrat, en une étape d'implantation, un domaine de dopage d'isolation (116) est généré au-dessous du domaine de collecteur, de manière que le domaine de collecteur est isolé électriquement du substrat,
**caractérisé en ce que**
l'étape d'implantation est effectuée de manière que, dans la zone d'une surface limite entre le domaine de collecteur (11, 111) et le domaine de dopage d'isolation (116) est réalisée une transition p-n qui, dans l'ensemble du domaine de transistor bipolaire actif respectif, n'est pas disposée plus profondément que l'arête inférieure des domaines d'isolation de champ (2) plats.

25. Procédé selon la revendication 24, dans lequel, pendant l'étape d'implantation visant à produire le domaine de collecteur, une deuxième étape d'implantation, visant à rendre amorphe, au moins partiellement, le domaine de collecteur, est accomplie.

26. Procédé selon la revendication 25, dans lequel une étape de recristallisation du domaine de collecteur est accomplie après la deuxième étape d'implantation.

27. Procédé selon l'une des revendications 24 à 26, dans lequel un tronçon de couche du domaine de contact de base, situé côté substrat, prévu dans l'empilement de couches de base du premier type de transistor, est déposé simultanément à un tronçon de couche, situé côté base, de la barre transversale de T de l'émetteur dans le deuxième type de transistor.

28. Procédé selon l'une des revendications 24 à 27, dans lequel un tronçon de couche du domaine de contact de base, situé côté émetteur, prévu dans l'empilement de couches de base du premier type de transistor, est déposé simultanément à un tronçon de couche, situé côté contact, de la barre transversale de T de l'émetteur dans le deuxième type de transistor.

29. Procédé selon l'une des revendications 24 à 28, dans lequel le module de procédé bipolaire, dans le cadre du procédé CMOS, est effectué subséquemment à une structuration de grille et une formation d'éléments d'espacement de grille et avant l'implantation des domaines de source et de drain.

30. Procédé selon l'une des revendications 24 à 29, dans lequel les transistors bipolaires sont fabriqués sur un substrat SOI.

31. Procédé selon la revendication 30, dans lequel les transistors bipolaires sont fabriqués sur un substrat SOI ayant une couche de couverture en Si mince, d'une épaisseur de couche inférieure à 50 nm.

32. Procédé de fabrication d'un dispositif semi-conducteur CBiMOS ou CBICMOS, **caractérisé par** un module de procédé intégré dans le procédé, avec les étapes du procédé selon l'une des revendications 24 à 31.
